(19) Europäisches Patentamt
European Patent Office
Office européen des brevets

(11) EP 3 196 263 B1

(12) **EUROPEAN PATENT SPECIFICATION**

(45) Date of publication and mention of the grant of the patent:
**01.09.2021 Bulletin 2021/35**

(21) Application number: **15842098.4**

(22) Date of filing: **18.09.2015**

(51) Int Cl.:
***C09D 5/44*** *(2006.01)* ***C25D 13/12*** *(2006.01)*
***C25D 15/02*** *(2006.01)* ***H01L 23/373*** *(2006.01)*
***H01L 23/498*** *(2006.01)* ***H05K 1/05*** *(2006.01)*
*C09D 7/61 (2018.01)* *C09D 183/04 (2006.01)*
*C09D 183/06 (2006.01)* *H01L 23/14 (2006.01)*
*H05K 3/44 (2006.01)*

(86) International application number:
**PCT/JP2015/076804**

(87) International publication number:
**WO 2016/043331 (24.03.2016 Gazette 2016/12)**

# (54) ELECTRODEPOSITION LIQUID, AND PROCESS FOR PRODUCING METAL CORE SUBSTRATE

ELEKTROTAUCHFLÜSSIGKEIT, UND VERFAHREN ZUR HERSTELLUNG EINES METALLKERNSUBSTRATS

LIQUIDE D'ÉLECTRODÉPOSITION, ET PROCÉDÉ POUR LA PRODUCTION D'UN SUBSTRAT À NOYAU MÉTALLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.09.2014 JP 2014192033**

(43) Date of publication of application:
**26.07.2017 Bulletin 2017/30**

(73) Proprietor: **Mie University**
**Tsu-shi, Mie 514-8507 (JP)**

(72) Inventors:
- **AOKI, Yusuke**
**Tsu-shi**
**Mie 514-8507 (JP)**
- **KANO, Mikihito**
**Tsu-shi**
**Mie 514-8507 (JP)**
- **KASANO, Kazuhiko**
**Matsusaka-shi**
**Mie 519-2145 (JP)**

(74) Representative: **Vigand, Philippe et al**
**Novagraaf International SA**
**Chemin de l'Echo 3**
**1213 Onex - Genève (CH)**

(56) References cited:
**WO-A2-2014/150841**
**JP-A- H0 586 194**
**JP-A- S6 320 374**
**JP-A- S6 353 296**
**JP-A- S60 207 392**
**JP-A- 2000 345 370**
**JP-A- 2000 345 370**
**JP-A- 2003 209 329**
**JP-A- 2009 043 914**
**JP-B2- 3 274 154**
**US-A- 4 755 551**

- **None**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 196 263 B1

## Description

[Technical Field]

The present invention relates to an electrophoretic deposition fluid, and a method for fabricating a metal core substrate.

[Background Art]

In recent years, due to high-power of power semiconductors and size reduction and integration of electronic circuits, in particularly, CPU-related parts, heat generation in devices is an issue. Thus, a demand for a substrate that has high heat dissipation properties is increasing. One substrate which has gained particular interest is a metal core substrate in which a conductive substrate, such as a metal substrate, is coated with a layer having high heat dissipation properties and high electrical insulating properties.

For example, a ceramic directly coated a conductive substrate, or a resin/ceramics filler compound is used as an electrical insulating layer of the metal core substrate. For example, a metal core substrate is disclosed in which a carbon substrate is coated with aluminum nitride by electrophoretic deposition using a polyimide as a binder (e.g., see PTL 1). Where the electrophoretic deposition is used, heat treatment of at least 300 degrees Celsius is required to fix a ceramic layer to a conductive substrate, and, due to the difference in coefficient of thermal expansion between the conductive substrate and the ceramic layer, a problem occurs, such as warpage of the substrate after coating, separation of the ceramic layer from the conductive substrate, or cracking of the ceramic layer. Thus, it is difficult to form a ceramic layer that has high thermal conductivity and high electrical insulating properties on a conductive substrate. To overcome this, PTL 1 employs coating a carbon substrate which has a small coefficient of thermal expansion, as compared to a metal substrate.

In addition, PTL 2 discloses powdered resin linear organopolysiloxane compositions. PTL 3 discloses a composition of polysiloxane resin containing a cationic functional group, a coating composition made by using it, and production of the resin composition. PTL 4 discloses an electrodeposition resinous paint composition.

[Citation List]

[Patent Literature]

[PTL 1] Japanese Unexamined Patent Application Publication No. 2003-209329
[PTL 2] International Application Publication No. 2014/150841
[PTL 3] Japanese Patent Publication No. 3274154
[PTL 4] United States Patent Publication No. 4,755,551

[Summary of Invention]

[Technical Problem]

However, since the metal core substrate disclosed in PTL 1 employs a carbon substrate, the metal core substrate has low heat dissipation performance, as compared to the use of metal substrate as a conductive substrate.

Moreover, if a resin/ceramics filler compound is used, the operating temperature of a substrate (metal core substrate) coated with a conductive substrate is limited by the heat resistant performance of the resin layer. Thus, it is difficult to obtain a metal core substrate that has high thermal conductivity and high electrical insulating properties.

The present invention is made to solve the above problems, and has an object to provide a metal core substrate which has high thermal conductivity and high electrical insulating properties, an electrophoretic deposition fluid for use in fabricating the metal core substrate, and a method for fabricating the metal core substrate.

[Solution to Problem]

In order to achieve the above object, an electrophoretic deposition fluid is defined according to the appended claims. It comprises an electrophoretic deposition fluid for use in electrophoretic deposition, the electrophoretic deposition fluid comprising ceramic particles for coating a metal substrate and a binder which binds the ceramic particles, the binder comprising an organopolysiloxane composition.

According to the present aspect, the electrophoretic deposition fluid containing the organopolysiloxane composition allows the metal substrate to be coated with a coating material, which is a ceramic material, by the electrophoretic deposition, while flexibly bonding the ceramic material. Thus, a ceramic layer can be formed that is excellent in heat resistance and ability to relax stress due to temperature change.

Moreover, the organopolysiloxane composition is a raw material of an organopolysiloxane-based organic-inorganic hybrid material.

According to the present aspect, use of the electrophoretic deposition fluid comprising a heat-resistant organopolysiloxane-based organic-inorganic hybrid material, as a binder, allows the metal substrate to be coated with the ceramic particles while more strongly binding the ceramic particles. Thus, a ceramic layer (electrical insulating layer) can be formed that is excellent in heat resistance and ability to relax thermal stress due to temperature change.

Moreover, in order to achieve the above object, a metal core substrate according to one aspect of the present invention includes a metal substrate; and an electrical insulating layer on the metal substrate, wherein the electrical insulating layer contains ceramic particles and a binder which binds the ceramic particles, and the metal core substrate has thermal conductivity of 2 W/mK or greater and an electrical breakdown strength of 50 kV/mm or greater, and heat-resistant temperature of the metal core substrate is 200 degrees Celsius or greater.

According to the present aspect, the metal substrate can be coated with a coating material which is a ceramic material, while flexibly bonding the ceramic material. Thus, a metal core substrate that has high thermal conductivity and high electrical insulating properties can be provided.

For example, in the metal core substrate the binder may comprise an organopolysiloxane composition cured product.

According to the present aspect, use of the electrophoretic deposition fluid containing the heat-resistant organopolysiloxane composition allows the ceramic particles to be bound flexibly. Thus, a ceramic layer (electrical insulating layer) can be formed that is excellent in heat resistance and ability to relax thermal stress due to temperature change.

For example, in the metal core substrate the organopolysiloxane composition cured product may comprise an organopolysiloxane-based organic-inorganic hybrid material.

According to the present aspect, use of the heat-resistant organopolysiloxane-based organic-inorganic hybrid material, as a binder, allows the ceramic particles to be bound more strongly. Thus, a ceramic layer (electrical insulating layer) can be formed that is excellent in heat resistance and ability to relax thermal stress due to temperature change.

For example, in the metal core substrate the electrical insulating layer may be selectively formed on the metal substrate.

According to the present aspect, a portion of the metal substrate is exposed from the electrical insulating layer, thereby achieving more improved heat dissipation efficiency.

For example, in the metal core substrate the metal substrate may include an interconnect layer on the electrical insulating layer.

According to the present aspect, an electronic circuit board substrate having excellent high thermal conductivity and high electrical insulating properties can be provided.

Moreover, in order to achieve the above object, a method for fabricating a metal core substrate according to one aspect of the present invention includes: forming an electrophoretic deposition fluid containing ceramic particles and a binder which binds the ceramic particles; and selectively forming an electrical insulating layer on a surface of a metal substrate by electrophoretic deposition using the electrophoretic deposition fluid, the electrical insulating layer comprising the ceramic particles.

According to the present aspect, the surface of the electrophoretic deposition film has a uniform shape, and the electrophoretic deposition film formed on the metal core substrate has such flexibility that the electrophoretic deposition film remains adhered to the metal core substrate even if the metal core substrate is bent. Thus, the metal core substrate having high thermal conductivity and high electrical insulating properties can be fabricated.

Here, the electrical insulating layer may be selectively formed by the electrophoretic deposition using a current that has a current density dependent on a molecular weight of the binder.

According to the present aspect, a ratio of the binder in the electrophoretic deposition film is controlled by the electrophoretic deposition which uses current having an appropriate current density dependent of a molecular weight of the binder, thereby controlling the hardness and heat resistance of the electrophoretic deposition film.

Moreover, the method may further include forming an interconnect layer on the electrical insulating layer by adhesion via an electrophoretic deposition film.

According to the present aspect, the interconnect layer can be formed on the electrical insulating layer by sticking the interconnect layer to the metal core substrate via the electrophoretic deposition film in an uncured state and in a semi-cured state and the curing of the binder material by the heat treatment.

Moreover, in order to achieve the above object, a method for fabricating the metal core substrate includes: carrying out plasma electrolytic oxidation on a surface of a metal substrate; and sealing the micropores in film formed on the surface of the metal substrate by the plasma electrolytic oxidation, by electrophoretic deposition using an electrophoretic deposition fluid containing a binder.

According to the present aspect, the metal core substrate having more excellent high thermal conductivity and high electrical insulating properties can be fabricated. Thus, a metal core substrate that is suitable for use as an electronic circuit board substrate is fabricated.

[Advantageous Effects of Invention]

According to the present invention, the metal core substrate having high thermal conductivity and high electrical insulating properties, and the method for fabricating the metal core substrate are provided.

[Brief Description of Drawings]

[FIG. 1]
FIG. 1 is a cross-sectional view showing a structure of a metal core substrate according to Embodiment 1 which is not claimed.
[FIG. 2]
FIG. 2 shows flowcharts illustrating processes of fabricating the metal core substrate according to Embodiment 1.
[FIG. 3A]
FIG. 3A is a schematic block diagram of an electrophoretic deposition device according to Embodiment 1.
[FIG. 3B]
FIG. 3B is a diagram illustrating a process of forming an electrophoretic deposition film according to Embodiment 1.
[FIG. 4]
FIG. 4 is a diagram for illustrating characteristics of a binder according to Embodiment 1.
[FIG. 5]
FIG. 5 is a diagram illustrating procedure for obtaining an electrophoretic deposition fluid according to Embodiment 1.
[FIG. 6]
FIG. 6 is a diagram illustrating structures of a raw material of the binder and its cured product according to Embodiment 1.
[FIG. 7]
FIG. 7 is a diagram illustrating the condition of a surface of the electrophoretic deposition film according to Embodiment 1.
[FIG. 8]
FIG. 8 is a diagram illustrating an evaluation device for thermal conductivity according to Embodiment 1.
[FIG. 9]
FIG. 9 is a diagram illustrating changes in thermal conductivity of the electrophoretic deposition film according to Embodiment 1.
[FIG. 10]
FIG. 10 is a diagram illustrating an evaluation device for dielectric withstand voltage of the electrophoretic deposition film according to Embodiment 1.
[FIG. 11]
FIG. 11 summarizes characteristics of the metal core substrates according to Embodiment 1, with respect to the hardness, thermal conductivity, and electrical breakdown strength of the electrophoretic deposition film.
[FIG. 12]
FIG. 12 shows diagrams illustrating results of measurement of the hardness of electrophoretic deposition films that are obtained under different current conditions of the electrophoretic deposition for the metal core substrates according to the present embodiment.
[FIG. 13]
FIG. 13 shows diagrams illustrating results of measurement of the hardness of electrophoretic deposition films obtained under different current conditions of the electrophoretic deposition ((a) of FIG. 13), and estimated amounts of the binder components in the electrophoretic deposition films ((b) of FIG. 13), for the metal core substrates according to the present embodiment.
[FIG. 14]
FIG. 14 shows diagrams illustrating deposition speeds of the binder components in the electrophoretic deposition films that are obtained under different current conditions of the electrophoretic deposition for the metal core substrates according to the present embodiment.
[FIG. 15]

FIG. 15 shows diagrams illustrating results of measurement of the heat resistances of the electrophoretic deposition films obtained under different current conditions of the electrophoretic deposition for the metal core substrates according to the present embodiment.

[FIG. 16]

FIG. 16 shows diagrams illustrating a method of evaluating (estimating) the electrophoretic deposition film composition ratio.

[FIG. 17]

FIG. 17 shows diagrams illustrating details of the method of "estimation of alumina-to-binder ratio (weight ratio) by TG" illustrated in (b) of FIG. 16.

[FIG. 18]

FIG. 18 shows diagrams illustrating details of the method of "measurement of specific gravity of electrophoretic deposition film by the Archimedes method" that is illustrated in (b) of FIG. 16.

[FIG. 19]

FIG. 19 is a diagram illustrating an example of a volume ratio of the electrophoretic deposition film that is calculated from the "alumina-to-binder ratio (weight ratio) by TG" illustrated in FIG. 17 and the "specific gravity of electrophoretic deposition film by the Archimedes method" illustrated in FIG. 18.

[FIG. 20]

FIG. 20 shows diagrams illustrating an example of changes in structure of the electrophoretic deposition film according to changes in added amount of ES-PDMS in the electrophoretic deposition fluid.

[FIG. 21]

FIG. 21 is a diagram illustrating an example of changes in structure of the electrophoretic deposition film according to changes in molecular weight of ES-PDMS in the electrophoretic deposition fluid.

[FIG. 22]

FIG. 22 shows diagrams illustrating results of comparison between guesses and actual observed values of the thermal conductivity of the metal core substrates resulting from the Bruggeman equation.

[FIG. 23]

FIG. 23 is a diagram illustrating characteristics of metal core substrates fabricated using various electrophoretic deposition fluids.

[FIG. 24]

FIG. 24 is a graph illustrating some of results of measurement of the "thermal conductivity (W/mK)," among the measurement results illustrated in FIG. 23.

[FIG. 25]

FIG. 25 is a graph illustrating some of results of measurement (including additional measurement results) of the "heat-resistant temperature (temperature at 3% weight loss) (degrees Celsius)," among the measurement results illustrated in FIG. 23.

[FIG. 26]

FIG. 26 shows diagrams illustrating measurements of the relative dielectric constants of the electrophoretic deposition films included in the two metal core substrates 1 according to the present embodiment, and estimates of the alumina occupancy determined using the measurements, for example.

[FIG. 27]

FIG. 27 is a diagram illustrating a plasma electrolytic oxidation (PEO) apparatus according to Embodiment 2.

[FIG. 28]

FIG. 28 is a diagram illustrating characteristics of the electrophoretic deposition film subjected to plasma electrolytic oxidation according to Embodiment 2.

[FIG. 29A]

FIG. 29A is a diagram illustrating a surface of a PEO film prior to a sealing process according to Embodiment 2.

[FIG. 29B]

FIG. 29B is a diagram illustrating the surface of the PEO film after the sealing process according to Embodiment 2.

[FIG. 29C]

FIG. 29C is a diagram illustrating the surface of the PEO film after the sealing process according to Embodiment 2.

[FIG. 30]

FIG. 30 is a diagram illustrating the electrical breakdown strength of each film according to Embodiment 2.

[FIG. 31]

FIG. 31 is a diagram illustrating the thermal conductivity and dielectric withstand voltage of each film according to Embodiment 2.

[FIG. 32]

FIG. 32 shows diagrams illustrating the thermal conductivity before and after the sealing process according to Embodiment 2.

[Description of Embodiments]

Hereinafter, embodiments are described, with reference to the accompanying drawings. Values, shapes, materials, components, and arrangement and connection between the components, steps and the order of steps, etc., shown in the following embodiments are merely illustrative and not intended to limit the present invention. The present invention is indicated by the appended claims. Thus, among the components of the embodiments below, components not recited in any one of the independent claims are not essential to achieve the present invention, but are described as components for preferable embodiments.

Embodiment 1

[1. Configuration of Metal Core Substrate]

First, a substrate having a metal core substrate according to an embodiment is described, with reference to FIG. 1. FIG. 1 is a cross-sectional view showing a structure of the metal core substrate according to the present embodiment.

As illustrated in FIG. 1, a metal core substrate 1 according to the present embodiment includes a metal substrate 10 and an electrical insulating layer 12. The metal core substrate 1 also includes an interconnect layer 14 formed on the electrical insulating layer 12. The metal core substrate 1 and the interconnect layer 14 constitute a circuit board 2.

The metal substrate 10 is configured of an aluminum substrate, for example. The electrical insulating layer 12 comprises, for example, alumina, and is formed on a surface of the metal substrate 10 by electrophoretic deposition. In other words, the metal substrate 10 is coated with the electrical insulating layer 12. The metal surface coating may be selectively carried out on the substrate by using a photolithography technique.

Further, the interconnect layer 14 comprising, for example, copper is formed on the electrical insulating layer 12 by patterning.

According to this configuration, heat that is generated by parts that operate at high temperatures can be efficiently released to outside by exposing the metal core substrate 1 and mounting a heat dissipating part, such as a heat sink, directly on the metal core substrate 1.

[2. Method for Fabricating Metal Core Substrate]

Next, processes for fabricating the metal core substrate according to the present embodiment are described.

FIG. 2 shows flowcharts illustrating the processes of fabricating the metal core substrate according to the present embodiment. There are two methods for fabricating the metal core substrate according to the present embodiment, which are: (1) forming an electrophoretic deposition film on the metal substrate 10 by electrophoretic deposition; and (2) forming a plasma electrolytic oxidation film on the metal substrate 10 and then performing a sealing process by electrophoretic deposition.

According to the fabricating method of (1) forming an electrophoretic deposition film on the metal substrate 10 by electrophoretic deposition, initially, an aluminum substrate which is to be the metal substrate 10 is prepared and cleaned (step S10), as illustrated in (a) of FIG. 2. Then, the electrophoretic deposition mentioned above is performed to form an electrophoretic deposition film (the electrical insulating layer 12) on the aluminum substrate (step S12). Note that an electrophoretic deposition fluid for use in the electrophoretic deposition is prepared. Moreover, when forming the electrophoretic deposition film, a portion of the aluminum substrate may be exposed from the electrophoretic deposition film to achieve an improved heat dissipation efficiency of the metal substrate 10. Note that a layer that is formed by the electrophoretic deposition is referred to as the electrophoretic deposition film. Further, the interconnect layer 14 is formed on the electrophoretic deposition film (the electrical insulating layer 12) (step S14). This completes the circuit board 2. The interconnect layer 14 may be formed on the electrophoretic deposition film by sticking the interconnect layer 14 and the aluminum substrate together via the electrophoretic deposition film in a semi-cured state and curing of the binder component (by the heat treatment).

According to the fabrication method of (2) forming a plasma electrolytic oxidation film on the metal substrate 10 and then performing the sealing process by electrophoretic deposition, initially, an aluminum substrate which is to be the metal substrate 10 is prepared and cleaned (step S10), as illustrated in (b) of FIG. 2. Next, plasma electrolytic oxidation is carried out to form a plasma electrolytic oxidation film (PEO film) on the aluminum substrate (step S22). Then, a sealing process is performed in which the electrophoretic deposition film is formed on a surface of the plasma electrolytic oxidation film by the electrophoretic deposition mentioned above (step S23). At this time, a portion of the aluminum substrate may be exposed from the electrophoretic deposition film to achieve an improved heat dissipation efficiency of the metal substrate 10. Further, the interconnect layer 14 is formed on the plasma electrolytic oxidation film (the electrical insulating layer 12) subjected to the sealing process (step S14). This completes the circuit board 2.

In the following, the fabrication method of (1) forming the electrophoretic deposition film on the metal substrate 10 by the electrophoretic deposition set forth above is described in detail. Note that the fabrication method of (2) forming the plasma electrolytic oxidation film on the metal substrate 10 and then performing the sealing process by the electrophoretic deposition is described in detail with reference to Embodiment 2.

[3. Formation of Electrophoretic Deposition Film by Electrophoretic Deposition]

Referring to FIGS. 3A, 3B, and 4 to 11, the fabrication method in which the electrophoretic deposition film is formed on the metal substrate 10 by the electrophoretic deposition is described. FIG. 3A is a schematic block diagram of an electrophoretic deposition device according to the present embodiment. FIG. 3B is a diagram illustrating how the electrophoretic deposition film is formed according to the present embodiment. FIG. 4 is a diagram for illustrating characteristics of a binder. FIG. 5 is a diagram illustrating the procedure for obtaining the electrophoretic deposition fluid according to the present embodiment.

The electrical insulating layer 12 is formed on the metal substrate 10 by electrophoretic deposition. The electrophoretic deposition is carried out by an electrophoretic deposition device 20 described below.

As illustrated in FIG. 3A, the electrophoretic deposition device 20 includes a container 22, the electrophoretic deposition fluid in the container 22, electrodes 10a and 10b bathed in the electrophoretic deposition fluid, and power supply 26 connected to the electrodes 10a and 10b.

The electrode 10a is configured of an aluminum substrate, for example. The electrode 10b is formed of a stainless steel material or a carbon material, for example. Positive voltage is applied to the electrode 10a and negative voltage is applied to the electrode 10b. Thus, the electrode 10a is anode and the electrode 10b is cathode. Hereinafter, the electrode 10a and the electrode 10b are referred to as an aluminum substrate 10a and an SUS substrate 10b, respectively.

Moreover, in the electrophoretic deposition fluid, globular alumina particles 28a, which are examples of ceramic particles, are floating. In the electrophoretic deposition, the alumina particles 28a are negatively charged in the solution. As illustrated in FIGS. 3A and 3B, the alumina particles 28a flow to the aluminum substrate 10a, which is anode, due to application of an electric field, and are fixed or deposited on the aluminum substrate 10a. At this time, organic-inorganic hybrid material ingredients subjected to the electrophoretic deposition, together with the alumina particles 28a, are in uncured states or in semi-cured states, after which the ingredients are hydrolyzed in the presence of water and cured by polycondensation reaction to yield an organic-inorganic hybrid material, and then the organic-inorganic hybrid material serves as a binder 28b in the electrophoretic deposition film, as illustrated in FIG. 4.

Thus, the aluminum substrate 10a in the present embodiment turns into the metal substrate 10 in the metal core substrate 1, and a ceramic layer comprising the alumina particles 28a and the binder 28b that are adhered to and layered on the surface of the aluminum substrate 10a turn into the electrical insulating layer 12 of the metal core substrate 1.

Note that in the electrophoretic deposition device 20 illustrated in FIG. 3A, the electrical insulating layer 12 is formed on a surface of the aluminum substrate 10a on the side facing the SUS substrate 10b. Thus, to form the electrical insulating layer 12 on both sides of the aluminum substrate 10a, preferably, the orientation of the aluminum substrate 10a is flipped over or two SUS substrates 10b are disposed facing both sides of the aluminum substrate 10a.

The electrophoretic deposition fluid 28 is obtained by the procedure illustrated in FIG. 5.

Initially, prepare globular alumina $Al_2O_3$ (the alumina particles 28a). The alumina particles 28a are dried at 130 degrees Celsius for 2 hours. Then, dehydrated isopropyl alcohol (IPA) and monochloroacetic acid (MCAA), which is stabilizer, are added. The electrophoretic deposition fluid 28 at this time is a blend of, for example, 15 wt% of alpha alumina (Sumicorundum AA-05 produced by Sumitomo Chemical Co., Ltd.) which has purity of 99.9% or greater and an average particle size of 0.5 $\mu$m, 12.75 wt% of MCAA (chloroacetic acid produced by Wako Pure Chemical Industries, Ltd.), and 72.25 wt% of dry IPA (2-propanol (super dry) produced by Wako Pure Chemical Industries, Ltd.).

Next, as illustrated in FIG. 5, the dry IPA and MCAA containing the alumina particles 28a are subjected to an ultrasonic homogenizing process for 3 minutes, using UP100H produced by Hielcher, and are bath sonicated for an hour using FU-3H produced by Fine. These processes are carried out while stirring the dry IPA and MCAA containing the alumina particles 28a so that the alumina particles 28a are uniformly mixed in the dry IPA and MCAA.

Next, a binder raw material is added to the dry IPA and MCAA containing the alumina particles 28a. An organopolysiloxane composition is used as the binder raw material. More specifically, for example, a mixed solution of metal alkoxide such as alkoxysilane, and organopolysiloxane terminated with metal alkoxide (organopolysiloxane terminally modified with metal alkoxide) is used. The mixed solution is referred to as a starting solution for an organopolysiloxane PDMS (polydimethylsiloxane)-based hybrid. An organopolysiloxane cured product obtained by the starting solution contacting water and being hydrated and dehydration-polycondensed is referred to as an organopolysiloxane-based organic-inorganic hybrid material. Use of the flexible, heat-resistant organopolysiloxane-based organic-inorganic hybrid material as the binder allows formation of a ceramic layer (electrical insulating layer) that is excellent in heat resistance

and ability to relax stress due to a temperature change.

For example, hybrid materials (PDMS-based hybrids) are used as the organopolysiloxane composition, the hybrid materials each comprising organopolysiloxane terminated with ethylsilicate (ES) as illustrated in (a) of FIG. 6 and ethylsilicate (hereinafter, referred to as ES). The organopolysiloxane terminated with ethylsilicate included in each of the hybrid materials is one of: PDMS terminally modified with ethylsilicate having a mass-average molecular weight (hereinafter, also simply referred to as a molecular weight) of 8000 (referred to as ES-PDMS-A); PDMS terminally modified with ethylsilicate having a mass-average molecular weight of 22000 (referred to as ES-PDMS-B); PDMS terminally modified with ethylsilicate having a mass-average molecular weight of 42000 (referred to as ES-PDMS-C); and PDMS terminally modified with ethylsilicate having a mass-average molecular weight of 76000 (referred to as ES-PDMS-D).

Cured products obtained by the hydration and dehydration-polycondensation of these organopolysiloxane compositions turn to cured products which are crosslinked via silica nanoglass 29 as illustrated in (b) of FIG. 6, more specifically, organopolysiloxane-based organic-inorganic hybrid materials. The organopolysiloxane-based organic-inorganic hybrid materials have high heat resistance (200 degrees Celsius for a continuous time period, 400 degrees Celsius or greater for a short time period) and flexibility. With regard to the ethylsilicate illustrated in (a) of FIG. 6, n = 8 to 10, for example. Use of these materials makes the organopolysiloxane composition, as the binder material, less likely to hydrolyze in the electrophoretic deposition fluid and less likely to form an aggregate. Note that the method of synthesizing ES-PDMS-A, ES-PDMS-B, ES-PDMS-C, and ES-PDMS-D (they are collectively referred to as ES-PDMS) is as described below, for example.

For ES-PDMS-A, ES-PDMS-B, and ES-PDMS-C, in a molar ratio of ES : PDMS = 2 : 1, ES (ES45 produced by Tama Chemicals) and PDMS (YF3800 produced by Momentive Performance Materials Japan (mass-average molecular weight of 6000), XF-3905 (mass-average molecular weight of 20000), or YF-3057 (mass-average molecular weight of 40000)) are placed in a screw top vial and stirred for 30 minutes under a closed nitrogen atmosphere at 25 degrees Celsius, using a magnetic stirrer. Then, a solution, which is a prepared mixture of the same mol of titanium (IV) ethoxide (produced by Merck, hereinafter, abbreviated as "TTE") and DL-apple acid diethyl ester (produced by Tokyo Chemical Industry Co., Ltd., hereinafter abbreviated to as "MA"), is added to the mixed solution of ES and PDMS described above. Here, 0.0165 mol of the solution is added per mol of the mixed solution of ES and PDMS. Further, the mixed solution is stirred under a closed atmosphere at 130 degrees Celsius for 8 hours, using a magnetic stirrer. Reaction of the mixed solution at this time can be identified, using a Fourier transform infrared spectroscopy (FT-IR) and gel permeation chromatography (GPC). The above mixed solution of TTE and MA is produced by placing the same mol of TTE and MA into a screw top vial and stirring them at 25 degrees Celsius for 30 minutes (see Example 1 of WO2010/143357 (PTL 2)). The blending conditions and the conditions of production of ES-PDMS-D were the same as those for ES-PDMS-B, but the polymerization process was carried out at 130 degrees Celsius for 24 hours.

The step of adding the binder material to the dry IPA and MCAA containing the alumina particles 28a is carried out while stirring the dry IPA and MCAA containing the alumina particles 28a, as illustrated in FIG. 5.

As such, the electrophoretic deposition fluid is obtained.

Next, using the electrophoretic deposition fluid thus formed, an electrophoretic deposition film (the electrical insulating layer 12) is formed on the aluminum substrate 10a by the electrophoretic deposition. The electrophoretic deposition is carried out by the electrophoretic deposition device 20 illustrated in FIG. 3A. Pro-3900 produced by Anatech was used as the power supply.

Conditions for the electrophoretic deposition are using constant current and adjusting the electrophoretic deposition time as appropriate to yield an electrophoretic deposition film having a thickness of 50 $\mu$m, for example. After forming the electrophoretic deposition film having the thickness of 50 $\mu$m, the electrophoretic deposition film is heat treated at 250 degrees Celsius for 2 hours to obtain an electrocoating cured film, which is an electrophoretic deposition film cured product. Examples set forth hereinafter all describe the nature of the electrophoretic deposition films subjected to the heat treatment at 250 degrees Celsius for 2 hours. However, the cured product can be obtained under different temperature conditions in a range from, for example, room temperature to 300 degrees Celsius.

Here, the aluminum substrate 10a and the electrophoretic deposition film comprising alumina have different coefficients of thermal expansion. Thus, use of the above-described organopolysiloxane-based hybrid as the binder material can mitigate the difference in coefficient of thermal expansion between aluminum and alumina. Since the polymer (organopolysiloxane-based organic-inorganic hybrid material) obtained by heating the modified ES-PDMS has high heat resistance (200 degrees Celsius for a continuous time period, 400 degrees Celsius or greater for a short time period) and flexibility, the electrophoretic deposition film comprising alumina and the polymer, as the binder, has high heat resistance as well.

FIG. 7 is an optical microscope image showing a status of the surface of the electrophoretic deposition film formed on the aluminum substrate 10a. As illustrated in FIG. 7, it can be seen that the surface of the electrophoretic deposition film has a uniform shape. Moreover, the electrophoretic deposition film formed on the metal core substrate 1 has such flexibility that the electrophoretic deposition film still remains adhered to the metal core substrate 1 even if

the metal core substrate 1 is bent.

[4. Nature of Metal Core Substrate Having Electrophoretic Deposition Film Formed Thereon]

Now, the nature of the metal core substrate 1 in which the electrophoretic deposition film comprising alumina is formed on the aluminum substrate 10a, and preferred conditions for the electrophoretic deposition are described.

Initially, effects of addition of the modified ES-PDMS to the electrophoretic deposition fluid on the nature of the electrophoretic deposition film are described. The effects of addition of the modified ES-PDMS to the electrophoretic deposition fluid on the nature of the electrophoretic deposition film comprising alumina and formed on the aluminum substrate 10a depends on difference in molecular weight of the modified ES-PDMS and an added amount of the modified ES-PDMS in the electrophoretic deposition fluid.

Next, the thermal conductivity of the metal core substrate 1 is described.

FIG. 8 is a diagram illustrating an evaluation device for the thermal conductivity according to the present embodiment.

As illustrated in FIG. 8, an evaluation device 30 includes, on a thermal insulating material 31, a heater 32, an aluminum block 34, a sample 36, an aluminum block 34, and an air cooling fin 38. Thermal grease is applied between the heater 32 and the aluminum block 34, between the aluminum block 34 and the sample 36, between the sample 36 and the aluminum block 34, and between the aluminum block 34 and the air cooling fin 38. A hole is formed in each of the two aluminum blocks 34, through which a thermocouple is inserted and temperature T1 of the heater 32 and temperature T2 of the air cooling fin 38 are measured. If the heater 32 is heated at a constant power and given enough time, heat generated from the heater 32 is considered transferred to every sample and the amount of heat is considered equivalent to input power (= Q) of the heater 32. Thermal resistance is measured from a temperature difference $\Delta T = T1 - T2$ and heat flow Q between the aluminum blocks 34. The thermal resistance measured is the sum of the thermal resistances of the aluminum block 34 (half of the thickness of aluminum block 34), the sample 36, and the aluminum block 34 (half of the thickness of aluminum block 34), and the thermal contact resistance between the aluminum block 34 (half of the thickness of aluminum block 34) and the sample 36, and the thermal contact resistance between the aluminum block 34 and the sample 36. The thermal resistance of the sample 36 can be determined, without the sample 36, by measuring the thermal resistance in the same manner as mentioned above and subtracting the thermal resistance and thermal contact resistance of the components, other than those of the sample 36, from the total thermal resistance. Further, the thermal conductivity of the sample 36 can be determined from the thickness and the area of the sample 36.

Now, the thermal conductivity when the metal core substrate 1 is used as the sample 36 is shown below.

FIG. 9 is a diagram illustrating changes in thermal conductivity of the electrophoretic deposition film according to the present embodiment.

As illustrated in FIG. 9, as the electrophoretic deposition current density increases, the thermal conductivity of the electrophoretic deposition film decreases. Stated differently, as the electrophoretic deposition current density reduces, the thermal conductivity of the electrophoretic deposition film increases. This is due to the fact that the reduction of the current density densifies the electrophoretic deposition film and increases the alumina occupancy in the electrophoretic deposition film. Thus, the thermal conductivity of the electrophoretic deposition film can be increased by reducing the electrophoretic deposition current density at the electrophoretic deposition. However, it is difficult to form the electrophoretic deposition film uniformly over the entirety of the substrate when the current density is too low. Thus, preferably, the electrophoretic deposition current density is reduced to an extent that can achieve a uniform electrophoretic deposition film.

Next, the electrical breakdown strength of the metal core substrate 1 is described.

FIG. 10 is a diagram illustrating an evaluation device for electrical breakdown strength of the electrophoretic deposition film according to the present embodiment.

As illustrated in FIG. 10, an evaluation device 40 for electrical breakdown strength includes a lower electrode 42, a measurement specimen 44, an upper electrode 46, and a power supply 48 in a container. In the container, for example, fluorine-containing inert liquid, such as fluorinert (registered trademark) produced by 3M, is placed and the lower electrode 42, the measurement specimen 44, and the upper electrode 46 are disposed in the listed order in the fluorine-containing inert liquid. The power supply 48 is connected between the lower electrode 42 and the upper electrode 46.

The lower electrode 42 and the upper electrode 46 are each configured of a plate electrode made of a stainless steel, for example. The upper electrode 46, for example, has an end curvature of 10 mm, and a flat portion having a diameter of 10 mmcp. The lower electrode 42 is sized to place the measurement specimen 44 thereon, for example, 50 mmcp. A maximum voltage that can be applied between the lower electrode 42 and the upper electrode 46 from the power supply 48 is 10 kV. In the evaluation device 40 for electrical breakdown strength, the voltage applied between the lower electrode 42 and the upper electrode 46 is gradually increased and dielectric breakdown is considered occurred when a current of 5.0 mA or greater flows therebetween.

In this condition, electrical breakdown strength of the metal core substrate 1 as the measurement specimen 44 was measured. By way of example, the metal core substrate 1 having a thickness of 35 μm that is fabricated using an electrophoretic deposition fluid containing the modified ES-PDMS (ES-PDMS-A) having a molecular weight of 8000 achieved characteristics that the dielectric withstand voltage is 3.4 kV and the electrical breakdown strength is 98 kV/mm.

Here, FIG. 11 summarizes characteristics of the metal core substrates 1 according to the present embodiment, with respect to the hardness, thermal conductivity, and electrical breakdown strength of the electrophoretic deposition film. Here, the hardness of the electrophoretic deposition film refers to scratch hardness. The hardness of the electrophoretic deposition film is measured by, for example, a sclerometer (MODEL318-S produced by ERICHSEN). FIG. 11 shows characteristics of metal core substrates fabricated each using the electrophoretic deposition fluid that contains alumina particles and a PDMS-based hybrid ("modified PDMS" in the figure) which is a mixture of the ethylsilicate (ES) and one of the modified ES-PDMS-A (molecular weight Mw = 8000), the modified ES-PDMS-B (molecular weight Mw = 22000), and the modified ES-PDMS-C (molecular weight Mw = 42000).

The metal core substrates 1 are compared, the metal core substrates 1 each including the aluminum substrate 10a on which the electrophoretic deposition film is formed using the PDMS-based hybrid which is a blend of 5 parts by weight of ES (ES45) and 15 parts by weight of ES-PDMS (modified ES-PDMS-A, modified ES-PDMS-B, or modified ES-PDMS-C), among the PDMS-based hybrids illustrated in FIG. 11 ("modified PDMS" in the figure).

The hardness is 2.0 N when the modified ES-PDMS-A is used, 2.0 N when the modified ES-PDMS-B is used, and 1.0 N when the modified ES-PDMS-C is used. Thus, it can be seen that the electrophoretic deposition film having a high strength is obtained, particularly, when ES-PDMS-A or ES-PDMS-B is used.

The thermal conductivity is 2.4 W/mK when the modified ES-PDMS-A is used, 2.9 W/mK when the modified ES-PDMS-B is used, and 1.1 W/mK when the modified ES-PDMS-C is used. Thus, it can be seen that the electrophoretic deposition film having the highest thermal conductivity is obtained when the molecular weight is 22000.

The electrical breakdown strength is 76.0 kV/mm when the modified ES-PDMS-A is used, 97.1 kV/mm when the modified ES-PDMS-B is used, and 30.9 kV/mm when the modified ES-PDMS-C is used. Thus, it can be seen that the electrophoretic deposition film having the highest electrical breakdown strength is obtained when the molecular weight is 22000.

Moreover, the metal core substrates 1 are compared, the metal core substrates 1 each including the aluminum substrate 10a on which the electrophoretic deposition film is formed using the PDMS-based hybrid which is a blend of 5 parts by weight of the modified ES (ES45) and either 15 parts by weight or 17.5 parts by weight of ES-PDMS-A (molecular weight Mw = 8000), among the PDMS-based hybrids ("modified PDMS" in the figure) illustrated in FIG. 11.

The hardness is 2.0 N when the ES-PDMS-A loading is 15 parts by weight, and 3.3 N when the ES-PDMS-A loading is 17.5 parts by weight. Thus, it can be seen that higher ES-PDMS loading yields an electrophoretic deposition film having a higher strength.

The thermal conductivity is 2.4 W/mK when the ES-PDMS-A loading is 15 parts by weight, and 3.1 W/mK when the ES-PDMS-A loading is 17.5 parts by weight. Thus, it can be seen that higher ES-PDMS-A loading yields an electrophoretic deposition film having a higher thermal conductivity.

The electrical breakdown strength is 76.0 kV/mm when the ES-PDMS-A loading is 15 parts by weight, and 79.5 kV/mm when the ES-PDMS-A loading is 17.5 parts by weight. Thus, it can be seen that higher ES-PDMS-A loading yields an electrophoretic deposition film having higher electrical breakdown strength.

Moreover, the metal core substrates 1 are compared, the metal core substrates 1 each including the aluminum substrate 10a on which the electrophoretic deposition film is formed using the PDMS-based hybrid which is a blend of 17.5 parts by weight of ES-PDMS-A and either 5 parts by weight or 7.5 parts by weight of the modified ES, among the PDMS-based hybrids ("modified PDMS" in the figure) illustrated in FIG. 11.

The hardness is 3.3 N when the ES loading is 5 parts by weight, and 3.5 N when the ES loading is 7.5 parts by weight. Thus, it can be seen that higher ES loading yields an electrophoretic deposition film having a higher strength.

The thermal conductivity is 3.1 W/mK when the ES loading is 5 parts by weight, and 2.2 W/mK when the ES loading is 7.5 parts by weight. Thus, it can be seen that lower ES loading yields an electrophoretic deposition film having higher thermal conductivity.

The electrical breakdown strength is 79.5 kV/mm when the ES loading is 5 parts by weight, and 89.1 kV/mm when the ES loading is 7.5 parts by weight. Thus, it can be seen that higher ES loading yields an electrophoretic deposition film having higher electrical breakdown strength.

As compared to the electrophoretic deposition film obtained in Comparative Example (PTL1), the electrophoretic deposition films have high electrical insulating properties and high thermal conduction characteristics in all the examples above, as illustrated in FIG. 11.

The backbone PDMS having a molecular weight of less than 8000 (the modified ES-PDMS-A) produces the electrophoretic deposition film that exhibits insufficient stress relaxation property, and thus the substrate tends to have increased warpage. Moreover, the backbone PDMS having a molecular weight of 80000 or more is prone to separation of the components of the modified PDMS in the electrophoretic deposition fluid, and thus is not suitable to form a uniform

electrophoretic deposition film. The above results indicate that the modified ES-PDMS having a molecular weight of about 8000 to about 80000 is preferable.

From the foregoing, according to the present technology, use of the PDMS-based hybrid described above as the binder material of the electrophoretic deposition fluid to form the electrophoretic deposition film comprising alumina on the aluminum substrate 10a can mitigate the difference in coefficient of thermal expansion between aluminum and alumina. The cured product (polymer) obtained by heating the modified ES-PDMS has high heat resistance (200 degrees Celsius for a continuous time period, 400 degrees Celsius or greater for a short time period) and flexibility. Thus, the electrophoretic deposition film having high thermal conductivity and high dielectric withstand voltage can be obtained in the metal core substrate 1.

Note that the electrophoretic deposition film fabricated using the electrophoretic deposition fluid, which has been prepared by compounding 100 parts by weight of suspenstion (the dry IPA and MCAA containing the alumina particles), 5 parts by weight of ES, and 15 parts by weight of ES-PDMS-B, added thereto were stored at 300 degrees Celsius for 200 hours, and it is confirmed that the thermal conductivity, dielectric withstand voltage, and adhesion strength remained unchanged, and the electrophoretic deposition film was resistant to heat shock such as rapid cooling from 300 degrees Celsius to room temperature and rapid heating.

Moreover, a metal line layer may be formed on the metal core substrate 1, using the electrophoretic deposition film in an uncured state as an adhesion layer. As a base member, the electrophoretic deposition film having a thickness of 25 $\mu$m is formed on an aluminum substrate (A2017S) and a copper plate, using the electrophoretic deposition fluid having, added thereto, 5 parts by weight of ES and 15 parts by weight of the modified ES-PDMS which has a molecular weight of 22000, the aluminum substrate being degreased by ethanol and acetone and having a length of 80 mm, width of 20 mm, and thickness of 2 mm, the copper plate having a length of 80 mm, width of 20 mm, and thickness of 0.2 mm. Then, the electrodeposited surface of the aluminum plate and the electrodeposited surface of the copper plate are stuck together and pressed using two pinches, and subjected to heat treatment at 250 degrees Celsius for 2 hours to form a laminated structure comprising copper/electrical insulating layer/aluminum. Edge portions of the aluminum plate are pulled in opposite directions at a test speed of 5 mm/min, using a tensile tester (autograph series precision universal testing machine AGS-J produced by Shimadzu Corporation), in accordance with the tensile shear bond strength test method of rigid adhered according to JIS K6850. Stress when the surfaces adhered together are separated are divided by the bonding area (20 mm $\times$ 20 mm) to calculate adhesion strength (MPa) between the copper plate and the aluminum plate (MPa), and it is confirmed that the adhesion strength is 0.5 MPa (such as 1.8 MPa), for example.

Next, since more specific evaluation (measurement) of the characteristics of the metal core substrate 1 was carried out, in addition to the evaluation (measurement) of the characteristics of the metal core substrate 1 described above, its description is set forth below in sections: 4-1. Effects of Current Conditions of Electrophoretic Deposition on Electrophoretic Deposition Film Structure; 4-2. Effects of Current Conditions of Electrophoretic Deposition on Heat Resistance of Electrophoretic Deposition Film; 4-3. Measurement of Composition Ratio of Electrophoretic Deposition Film; and 4-4. Consideration of Dielectric Characteristics.

[4-1. Effects of Current Conditions of Electrophoretic Deposition on Electrophoretic Deposition Film Structure]

FIG. 12 shows diagrams illustrating results of measurement of the hardness of electrophoretic deposition films that are obtained under different current conditions of the electrophoretic deposition (current value) for the various metal core substrates 1 according to the present embodiment. Here, the measurement results are shown with respect to the hardness of six different electrophoretic deposition films of the metal core substrates 1. The six different electrophoretic deposition films were obtained by the electrophoretic deposition at current of 5A, 7.5A, 10A, and 12A, using six different electrophoretic deposition fluids. The six different electrophoretic deposition fluids used in fabricating the metal core substrates 1 contain PDMS-based hybrids that contain different loadings (g) of ES and different loadings (g) of ES-PDMS having different molecular weights (Mw). Note that the loading (g) is per 100 g of the electrophoretic deposition fluid. In the measurement results in the figure, "x" indicates that the electrophoretic deposition films fabricated under the condition all developed cracks, "Δ" indicates that some electrophoretic deposition films developed cracks, "O" indicates that all the electrophoretic deposition films developed no crack, and numeric values (N) noted with "Δ" or "O" indicate the hardness measured.

From the measurement results in FIG. 12, it is contemplated that when low current is applied at the electrophoretic deposition, dense alumina is likely to be deposited as the electrophoretic deposition film, and the electrophoretic deposition film is prone to cracks because of a low binder ratio.

FIG. 13 shows diagrams illustrating results of measurement of the hardness of electrophoretic deposition films that were obtained under different current conditions of the electrophoretic deposition (the current density) ((a) of FIG. 13), and estimated amounts of the binder components in the electrophoretic deposition films ((b) of FIG. 13), for the various metal core substrates 1 according to the present embodiment.

In other words, (a) of FIG. 13 is a graphical plot of the hardness (measurement) illustrated in FIG. 12, illustrating

the relationship of the current density (A/$cm^2$) versus the hardness (N) at the electrophoretic deposition, provided that some measurement results are added to the measurement results illustrated in FIG. 12. The four curves correspond to the (four) combinations of the loading (g) and molecular weight (Mw) of ES-PDMS comprising the PDMS-based hybrids that are contained in the electrophoretic deposition fluids used.

Part (b) of FIG. 13 shows the weight ratios (%; estimates) of the binder (resin) contained in the electrophoretic deposition films that are obtained using five different types of electrophoretic deposition fluids containing different loadings (g) of ES-PDMS having different molecular weights (Mw).

The following can be seen from (a) and (b) of FIG. 13. In other words, if the current density during the electrophoretic deposition is too small, the binder (resin) component adhered to the surface of the metal substrate 10 is relatively large in quantity, irrespective of the electrophoretic deposition, resulting in an increased weight ratio of the binder (see the data where the current density is 0.8 mA/$cm^2$ in (b) of FIG. 13). Moreover, as the current density during the electrophoretic deposition increases, the binder ratio in the electrophoretic deposition film increases (see the data where the current density is 2.0 mA/$cm^2$ or greater in (b) of FIG. 13) and the hardness of the electrophoretic deposition film decreases (see the data where the current density is 2.0 mA/$cm^2$ or greater in (a) of FIG. 13).

Moreover, the following can be seen from (a) of FIG. 13, with respect to the relationship between the molecular weight of ES-PDMS and the hardness of the electrophoretic deposition film. In other words, if the molecular weight of ES-PDMS is small, the hardness of the electrophoretic deposition film is great and the electrophoretic deposition film is prone to cracks. On the other hand, if the molecular weight of ES-PDMS is great, the hardness of the electrophoretic deposition film is small and the electrophoretic deposition film is less likely to develop cracks. Moreover, if the current during the electrophoretic deposition is increased, the electrophoretic deposition film is prone to be porous and prone to stress relaxation. Consequently, an electrophoretic deposition film having no crack is formed (i.e., the thermal conduction characteristic decreases because the electrophoretic deposition film is porous).

FIG. 14 shows diagrams illustrating deposition speeds of the binder components (estimate) in the electrophoretic deposition films that are obtained under different current conditions of the electrophoretic deposition (current or voltage) for the various metal core substrates 1 according to the present embodiment. In other words, (a) of FIG. 14 is the same as (b) of FIG. 13, and (b) of FIG. 14 illustrates curves which are obtained by converting the data indicated by ovals in (a) of FIG. 14 into deposition speeds of the binder components.

As can be seen from (b) of FIG. 14, the deposition speed of the binder component depends on the molecular weight of ES-PDMS comprising the PDMS-based hybrid contained in the electrophoretic deposition fluid. It is contemplated that use of ES-PDMS having a low molecular weight increases the deposition speed of the binder component at low current.

In summary of the findings obtained from FIGS. 12 to 14, the effects of the amount of current at the electrophoretic deposition on the alumina component and the binder component included in the electrophoretic deposition film are as follows.

(1) Effects on the alumina component

Alumina particles have a particle size distribution. In other words, when the current at the electrophoretic deposition is small, small alumina particles are likely to be electrodeposited. Moreover, as the amount of current increases, a relatively large amount of large alumina particles are deposited.

Stated differently, alumina particles having a narrow particle size distribution are deposited under a low current condition, whereas alumina particles having a wide particle size distribution are deposited under a high current condition.

Thus, the electrophoretic deposition film tends to be dense under low current condition, and the electrophoretic deposition film tends to be porous under large current condition.

(2) Effects on the binder component

The binder component is the same as the alumina particles in that the electrophoretic deposition rate increases with an increase in amount of current.

Strictly speaking, electrophoresis conditions of ES and ES-PDMS are different. To be more specific, as compared to ES-PDMS having a high molecular weight, ES having a low molecular weight is contemplated to be more prone to deposition even under a low current condition. Thus, although the ratio between ES, as the binder component, and ES-PDMS depends on the current condition, a difference in density between ES and ES-PDMS due to difference in molecular weight is subtle (the range of 1.04 to 1.2). For this reason, the composition of the electrophoretic deposition film is evaluated, assuming that the electrophoretic deposition film is the same as an electroless film even when the current condition is different.

A larger current condition results in a higher binder ratio in an electrophoretic deposition film.

[4-2. Effects of Current Conditions of Electrophoretic Deposition on Heat Resistance of Electrophoretic Deposition Film]

FIG. 15 shows diagrams illustrating results of measurement of the heat resistances of the electrophoretic deposition films that were obtained under different current conditions of the electrophoretic deposition (current density) for the various metal core substrates 1 according to the present embodiment. In other words, (a) of FIG. 15 illustrates temperature at which the weight of the electrophoretic deposition film reduces by 3% (temperature (degrees Celsius) at 3% weight loss), and (b) of FIG. 15 illustrates the percentage loss of weight of the electrophoretic deposition film at 600 degrees Celsius (weight loss @ 600 degrees Celsius (%)). In (a) and (b) of FIG. 15, the five curves correspond to the (five) combinations of the loading (g) and molecular weight (Mw) of ES-PDMS comprising the PDMS-based hybrids that are contained in the electrophoretic deposition fluids used.

It can be seen from the measurement results illustrated in FIG. 15 that an increase in ratio of ES-PDMS loaded in the electrophoretic deposition fluid reduces the heat resistance of a resultant electrophoretic deposition film.

Considering 4-1. Effects of Current Conditions of Electrophoretic Deposition on Electrophoretic Deposition Film Structure, and 4-2. Effects of Current Conditions of Electrophoretic Deposition on Heat Resistance of Electrophoretic Deposition Film described above, it can be seen that, in the step of forming (alternatively, selectively forming) an electrodeposited layer, a ratio of the binder in the electrophoretic deposition film is controlled by using electrophoretic deposition which uses a current having a current density dependent on a molecular weight of the binder, thereby controlling the hardness and heat resistance of the electrophoretic deposition film.

[4-3. Measurement of Composition Ratio of Electrophoretic Deposition Film]

A composition ratio of the electrophoretic deposition film formed on the metal core substrate 1 was evaluated. The evaluation method and results of the evaluation are now described.

FIG. 16 shows diagrams illustrating a method of evaluating (estimating) the electrophoretic deposition film composition ratio. In other words, (a) of FIG. 16 is a schematic view of a structure of the electrophoretic deposition film, and (b) of FIG. 16 is a flowchart illustrating the method of estimating the composition ratio.

As illustrated in (a) of FIG. 16, suppose that the electrophoretic deposition film comprises alumina, binder, and pores (air). Then, as illustrated in (b) of FIG. 16, the alumina-to-binder ratio (weight ratio) was estimated by thermogravimetric analysis (TG) while the specific gravity of the electrophoretic deposition film was measured by the Archimedes method to estimate volume ratios of alumina, binder, and pores in the electrophoretic deposition film from the obtained alumina-to-binder ratio (weight ratio) and specific gravity of the electrophoretic deposition film.

FIG. 17 shows diagrams illustrating details of the method of "estimation of alumina-to-binder ratio (weight ratio) by TG" illustrated in (b) of FIG. 16.

Initially, as illustrated in (a) of FIG. 17, an amount of weight loss of each of an electrophoretic deposition film comprising alumina and binder, an electrophoretic deposition film comprising alumina only, and a binder cured product when each is heated up to 1000 degrees Celsius is measured. Part (a) of FIG. 17 shows the measurement results. Here, the left diagram shows an amount of weight loss (residual weight (%)), due to temperature dependence, of the electrophoretic deposition film comprising alumina and binder (here, a binder formed using the PDMS-based hybrid in which ES and ES-PDMS-B having a molecular weight Mw of 22000 are blended in ES : ES-PDMS = 5:15), and the right diagram shows amounts of weight losses (residual weight (%)), due to temperature dependence, of the electrophoretic deposition film comprising alumina only ("binder-free electrophoretic deposition film") and a binder cured product ("ES + ES-PDMS").

Next, the weight ratios (wt%) of alumina and the binder are estimated from the amounts of weight losses determined, as illustrated in (b) of FIG. 17. Part (b) of FIG. 17 is a diagram illustrating the method of estimating the weight ratios. Here, a schematic view illustrating thermal weight loss of the electrophoretic deposition film; a schematic view illustrating the thermal weight loss when the electrophoretic deposition film is separated into the alumina component and the binder component; equation ($c = ax/100 + b (100-x)/100$, $x = 100 (c-b)/(a-b)$) showing the relationship between the weight ratio x of alumina, an amount of weight loss a (%) of ceramics, an amount of weight loss b (%) of the binder, and an amount of weight loss c (%) of the electrophoretic deposition film; and an example of the weight ratios of alumina and the binder obtained from the equation and the measurement results (a = 2.8%, b = 71.2%, c = 6.5%) illustrated in (a) of FIG. 17 are shown. An example is shown in which the weight ratio of the alumina component is 94.6% and the binder component is 5.4%.

FIG. 18 shows diagrams illustrating details of the method of "measurement of specific gravity of electrophoretic deposition film by the Archimedes method" that is illustrated in (b) of FIG. 16.

Part (a) of FIG. 18 shows an overview of an apparatus for the Archimedes method, and a formula for calculating specific gravity. The apparatus for the Archimedes method is illustrated in which a specific gravity measurement basket that is strung from an electrobalance placed above a beaker filled with IPA (specific gravity p = 0.785) is bathed in the beaker. Moreover, the formula for calculating the specific gravity is shown: specific gravity of object ds = {mass w

commensurating with the object weighed in an air/(w-mass w' commensurating with the object bathed in a liquid)} x (the specific gravity d1 of the liquid bathing the object).

Part (b) of FIG. 18 shows an example of calculation of specific gravity of the binder and specific gravity of the electrophoretic deposition film that are calculated by the method illustrated in (a) of FIG. 18. The figure illustrates an example in which the specific gravity of the binder is 1.1 $g/m^3$ and specific gravity of the electrophoretic deposition film is 3.30 $\pm$ 0.03 $g/m^3$.

FIG. 19 is a diagram illustrating an example of a volume ratio of the electrophoretic deposition film that is calculated from the "alumina-to-binder ratio (weight ratio) by TG" illustrated in FIG. 17 and the "specific gravity of electrophoretic deposition film by the Archimedes method" illustrated in FIG. 18. The figure illustrates an example of weight ratios (wt%), specific gravities ($g/cm^3$), and volume ratios (%) of alumina, binder, and pores comprising an electrophoretic deposition film that is formed by the electrophoretic deposition fluid which contains the PDMS-based hybrid in which ES and ES-PDMS having a molecular weight Mw of 22000 are blended in ES : ES-PDMS = 5 : 15, as described with reference to FIG. 17.

FIG. 20 shows diagrams illustrating an example of changes in structure of the electrophoretic deposition film associated with changes in added amount of ES-PDMS in the electrophoretic deposition fluid. The figure illustrates an example of actual measurements, by the method illustrated in FIGS. 16 to 19, of the weight ratios (wt%, (a) of FIG. 20) and volume ratios (%, (b) of FIG. 20, (c) of FIG. 20) of the components of the various electrophoretic deposition films. The molecular weight Mw of ES-PDMS used is 6000, and ES and ES-PDMS (ES : ES-PDMS) are blended in four combinations, 5 : 5, 5 : 10, 5 : 15, and 5 : 20.

As can be seen from the results shown in FIG. 20, an increase of the ES-PDMS loading, relative to ES, increases the volume of the binder component and the volume of the pore component each as a percentage of the electrophoretic deposition film.

FIG. 21 is a diagram illustrating an example of changes in structure (changes in volume ratio) of the electrophoretic deposition film associated with changes in molecular weight of ES-PDMS in the electrophoretic deposition fluid. The figure illustrates an example of actual measurements, by the method illustrated in FIGS. 16 to 19, of the volume ratios (%) of the components of the various electrophoretic deposition films. Results obtained when the molecular weight of ES-PDMS is 8000 and 22000 are shown.

As can be seen from the results shown in FIG. 21, the greater the molecular weight of ES-PDMS, the less the electrophoretic deposition film is prone to electrophoresis. This may relatively increase the alumina occupancy and may also increase the porosity.

FIG. 22 shows diagrams illustrating results of comparison between guesses and actual observed values of the thermal conductivity of the electrophoretic deposition films resulting from the Bruggeman equation. The thermal conductivity of a compound consisting of two components, a filler and a matrix, is expressed in the Bruggeman equation in (a) of FIG. 22. Part (b) of FIG. 22 is a diagram illustrating the relationship of the volume loading (%) of alumina versus the thermal conductivity (W/mK) of the electrophoretic deposition film comprising alumina and binder. The figure depicts a theoretical curve (guess) of the thermal conductivity resulting from the Bruggeman equation shown in (a) of FIG. 22, and actual observed values of the thermal conductivities of the electrophoretic deposition films that are obtained using ES-PDMS having the molecular weight of 22000 and using ES-PDMS having the molecular weight of 8000, provided that the thermal conductivity of the alumina is 20 W/mK and the thermal conductivity of the binder is 0.2 W/mK. Part (c) of FIG. 22 illustrates a comparison of the two actual observed values shown in (b) of FIG. 22 with the theoretical values (guesses).

As can be seen from (b) and (c) of FIG. 22, compared to the guesses of the thermal conductivity of the electrophoretic deposition film resulting from the Bruggeman equation, the actual observed values are small values. This is contemplated to be due to the effects of pores in the electrophoretic deposition film. As can be seen from the results in FIG. 20, the electrophoretic deposition film obtained using ES-PDMS having a greater molecular weight includes a greater pore component deposition. Thus, the actual observed values are far different from the theoretical values (guesses).

FIG. 23 is a diagram illustrating characteristics of metal core substrates 1 fabricated using various electrophoretic deposition fluids. The figure corresponds to the measurement results shown in FIG. 11 with additional measurement results, illustrating, from the left, "ES-PDMS type" (the molecular weight of ES-PDMS blended in electrophoretic deposition fluid), "ES45 loading (part)" (ES loading), "ES-PDMS loading (part)," "hardness (N)," "thermal conductivity (W/mK)," "electrical breakdown strength (kV/mm)," "heat-resistant temperature (temperature at 3% weight loss) (degrees Celsius)," "weight ratio (wt%) of binder component as a percentage of compound," "volume ratio of alumina (%)," "volume ratio of binder (%)", and "volume ratio of pores (air) (%)" of resulting electrophoretic deposition films.

It can be seen from the actual observed values shown in FIG. 23 that an increase of the ES-PDMS loading increases the binder component in the electrophoretic deposition film. At this time, the heat-resistant temperature tends to decrease due to an increase of the binder component.

Comparing the electrophoretic deposition films having the same loading of ES and the same loading of ES-PDMS (5 g of ES + 15 g of ES-PDMS), the heat resistance tends to increase due to an increase of the molecular weight of ES-PDMS. This is because an increase of the molecular weight of ES-PDMS reduces the binder component as a percentage of the electrophoretic deposition film. As illustrated in FIG. 22, without pores, the alumina occupancy (volume loading) needs to be 58% or greater to achieve 2.0 W/mK or greater of the compound thermal conductivity, and the alumina occupancy (volume loading) needs to be 65% or greater to achieve 3.0 W/mK or greater of the compound thermal conductivity. If the compound layer has pores (voids), on the other hand, the compound thermal conductivity decreases. If the porosity is low (5% or less), the relationship between the thermal conductivity ke of the compound and the thermal conductivity km of a matrix, where the porosity is f, is in accordance with the Bruggeman equation, assuming that small globular pores are uniformly distributed,

$$ke/km = (1-f)^{3/2}$$

According to this equation, it is surmised that when the porosity is 0.05 the thermal conductivity reduces by about 7.5%, and when the porosity is 0.1 the thermal conductivity reduces by about 15%. However, as the porosity increases, the pore size increases, and thus the gap from the compound thermal conductivity resulting from the above Bruggeman equation increases, thereby causing a sudden decrease of the thermal conductivity. Moreover, an increase of pores decreases the electrical insulating characteristic. In view of the above, desirably, the porosity is 5% or less.

Allowing for a decrease of the compound thermal conductivity due to the presence of pores, desirably, the alumina occupancy is 65% or greater. As illustrated in FIG. 23, the compound is produced where the percentage of alumina to the compound is 65% or greater and the percentage of pores (air) to the compound is 5% or less.

FIG. 24 is a graph illustrating some of results of measurement of the "thermal conductivity (W/mK)," among the measurement results illustrated in FIG. 23. Here, the relationship of an amount of PDMS (horizontal axis (g)) added and blended in a PDMS-based hybrid (5 g of ES and ES-PDMS) in 100 g of the electrophoretic deposition fluid versus the thermal conductivity (vertical axis (W/mK)) of the metal core substrate that is formed using the electrophoretic deposition fluid is plotted.

In FIG. 24, focusing on the thermal conductivities (the plots when the horizontal axis is 15 g) of the metal core substrates that are formed using the electrophoretic deposition fluids in which the PDMS-based hybrids of the same amount (5 g of ES and 15 g of ES-PDMS) is blended, it can be seen that when the molecular weight of PDMS is small (Mw = 8000), the amount of the binder tends to increase and, consequently, the alumina occupancy tends to decrease. Thus, the thermal conductivity decreases. When the molecular weight of PDMS is great (Mw = 22000), the amount of the binder reduces and the alumina occupancy increases relatively. Thus, the thermal conductivity increases. When the molecular weight of PDMS is further great (Mw = 76000), the amount of the binder further reduces. It is contemplated that the electrophoretic deposition film tends to be porous because a large current condition is used for the electrophoretic deposition. Consequently, the thermal conductivity decreases.

FIG. 25 is a graph illustrating some of results of measurement (including additional measurement results) of the "heat-resistant temperature (temperature at 3% weight loss) (degrees Celsius)," among the measurement results illustrated in FIG. 23. Here, the relationship of an amount of PDMS (horizontal axis (g)) added and blended in a PDMS-based hybrid (5 g of ES and PDMS) in 100 g of the electrophoretic deposition fluid versus the heat-resistant temperature (temperatures at 3% weight loss) (degree Celsius) of the electrophoretic deposition film that is formed using the electrophoretic deposition fluid is plotted.

It can be seen from the plot illustrated in FIG. 25 that an increase of the added amount of PDMS to the electrophoretic deposition fluid decreases the heat resistance. This is contemplated to be due to an increase of the polymer component in the electrophoretic deposition film. Moreover, even if the added amount of PDMS to the electrophoretic deposition fluid is the same, the polymer ratio in the electrophoretic deposition film depends on a molecular weight of PDMS, and the heat resistance changes. The greater the molecular weight of PDMS, the less the polymer component as a percentage of the electrophoretic deposition film, and, consequently, the heat resistance of the electrophoretic deposition film increases.

[4-4. Consideration of Dielectric Characteristics]

FIG. 26 shows diagrams illustrating measurements of the relative dielectric constants of the electrophoretic deposition films included in the two metal core substrates 1 according to the present embodiment, and estimates of the alumina occupancy determined using the measurements, etc. More specifically, (a) of FIG. 26 is a graph illustrating the measurements of the relative dielectric constants of the electrophoretic deposition films included in the two metal core substrates 1 according to the present embodiment at 1 kHz. Part (b) of FIG. 26 is the relationship based on the effective medium theory that is used to calculate the alumina occupancy in the electrophoretic deposition film from the measurements as shown in (a) of FIG. 26. Part (c) of FIG. 26 is a table showing: the measurements ("relative dielectric constant")

shown in (a) of FIG. 26; estimates of the alumina occupancy resulting from the measurements and the relationship shown in (b) of FIG. 26 ("estimate by measurement of the dielectric constant"); and alumina occupancies estimated from measurement of thermal weight and measurement of specific gravity ("estimate from TG measurement and specific gravity measurement"). The electrophoretic deposition films of the two metal core substrates 1 are those obtained when ES and ES-PDMS are blended in the PDMS-based hybrid in ES : ES-PDMS = 5:5 and in ES : ES-PDMS = 5 : 15.

The relative dielectric constants, at 1 kHz, of the electrophoretic deposition films that are obtained when ES : ES-PDMS = 5 : 5 and when ES : ES-PDMS = 5 : 15 are 6.9 and 5.9, respectively, as shown in the graph of (a) of FIG. 26 and the "relative dielectric constant" in the table of (c) of FIG. 26. The relationship shown in (b) of FIG. 26 holds between: the alumina loading X in the electrophoretic deposition film; the relative dielectric constant $\varepsilon_1$ of alumina; the relative dielectric constant $\varepsilon_2$ of the PDMS-based hybrid; and the relative dielectric constant $\varepsilon_{eff}$ of the electrophoretic deposition film. Here, in the relationship, 9.0 (literature value) is assigned to the relative dielectric constant $\varepsilon_1$ of alumina and 2.8 (@1 kHz) is assigned to the relative dielectric constant $\varepsilon_2$ of the PDMS-based hybrid to estimate alumina loading X, this results in 74% and 59% for the above two electrophoretic deposition films ("estimate by measurement of dielectric constant" in (c) of FIG. 26). The results are substantially equal to the estimations by measurement of thermal weight and measurement of specific gravity (78% and 53% shown in the "estimate from TG measurement and specific gravity measurement" of (c) of FIG. 26).

From the fact that the relative dielectric constants (6.9 and 5.9) of the electrophoretic deposition films according to the present embodiment are lower than the relative dielectric constant (9.0) of alumina, it can be seen that the metal core substrate according to the present embodiment is also useful as a substrate directed to a microwave device.

[5. Effects]

As described above, according to the metal core substrate of the present embodiment, an electrical-insulation heat-dissipation substrate having high heat resistance and thermal shock resistance can be formed. To be more specific, use of the electrophoretic deposition fluid that contains, as a binder, a flexible, heat-resistant polydimethylsiloxane-based organic-inorganic hybrid material allows formation of a ceramic layer (electrical insulating layer) that is excellent in heat resistance and ability to relax stress due to a temperature change.

Specifically, it can be seen that the metal core substrate according to the present embodiment has characteristics, including: (1) the ceramic layer does not separate from the metal core substrate even when the metal core substrate is bent; (2) 300 degrees Celsius of heat resistance and stress relaxation property that can withstand thermal shock from room temperature to 300 degrees Celsius; (3) high electrical insulating properties (3.0 kV/50 $\mu$m); (4) heat dissipation properties (2.5 W/mK); and (5) capability of applying an interconnect layer to the metal core substrate by adhesion via the electrophoretic deposition film. By way of example, a metal core substrate is achieved which has a thermal conductivity of 2 W/mK or greater and an electrical breakdown strength of 50 kV/mm or greater, and a heat-resistant temperature of 200 degrees Celsius or greater.

While the embodiment has been described with reference to the binder material being the organopolysiloxane-based organic-inorganic hybrid material, the binder material may be another material. For example, the binder material may be an organopolysiloxane composition cured product which contains the organopolysiloxane-based organic-inorganic hybrid material.

While the organopolydimethylsiloxane terminally modified with ethylsilicate (ES-PDMS) has been described as an example of the organopolysiloxane terminally modified with metal alkoxide, another organopolysiloxane terminally modified with metal alkoxide can be used. The organopolysiloxane terminally modified with metal alkoxide is the organopolysiloxane shown in the general formula (1) whose one or both terminals or at least one of side chains of the backbone is modified with the metal alkoxide as shown in the general formula (2), (3), or (4) or with a hydrolytic condensate of the metal alkoxide.

[Formula 1]

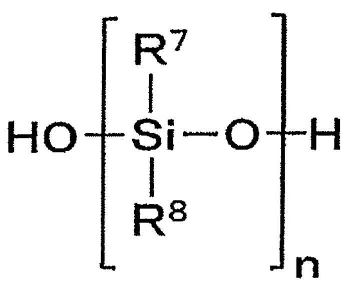

------- (1)

[Formula 2]

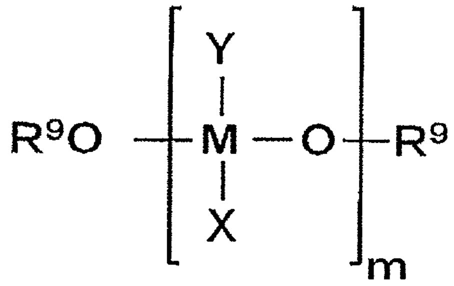

(2)

[Formula 3]

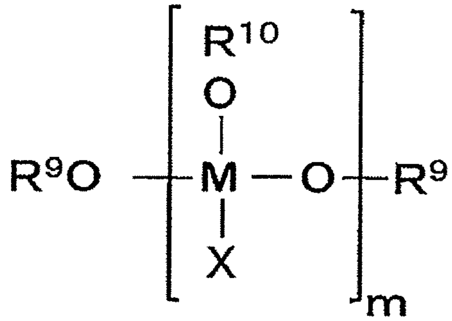

(3)

[Formula 4]

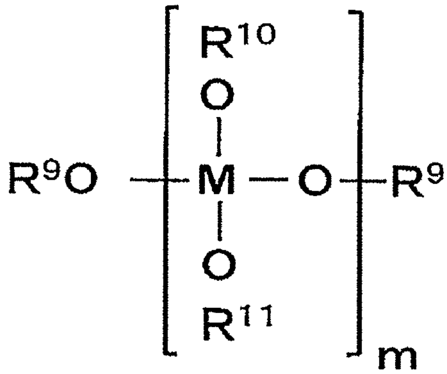

(4)

Suitable examples of the organopolysiloxane include polydialkylsiloxane, polydiarylsiloxane, and polyalkylarylsiloxane, more specifically, polydimethylsiloxane, polydiethylsiloxane, polydiphenylsiloxane, polymethylphenylsiloxane, and polydiphenyldimethylsiloxane. One of them may be used or two or more of them may be used together.

Metal alkoxide that modifies at least a portion of at least one end of the backbone or at least one of the side chains of the organopolysiloxane, is not particularly limited, but, in particularly, alkoxysilane is preferable. Examples of the alkoxysilane include tetraalkoxysilanes such as tetramethoxysilane, tetraethoxysilane, tetra-n-propoxysilane, tetra-i-propoxysilane, and tetra-n-butoxysilane; trialkoxysilanes such as methyltrimethoxysilane, methyltriethoxysilane, ethyltrimethoxysilane, ethyltriethoxysilane, n-propyltrimethoxysilane, n-propyltriethoxysilane, i-propyltrimethoxysilane, i-propyltriethoxysilane, n-butyltrimethoxysilane, n-butyltriethoxysilane, n-pentyltrimethoxysilane, n-hexyltrimethoxysilane, n-heptyltrimethoxysilane, n-octyltrimethoxysilane, vinyltrimethoxysilane, vinyltriethoxysilane, cyclohexyltrimethoxysilane, cyclohexyltriethoxysilane, phenyltrimethoxysilane, phenyltriethoxysilane, 3-chloropropyltrimethoxysilane, 3-chloropropyltriethoxysilane, 3,3,3-trifluoropropyltrimethoxysilane, 3,3,3-trifluoropropyltriethoxysilane, 3-aminopropyltrimethoxysilane, 3-aminopropyltriethoxysilane, 2-hydroxyethyltrimethoxysilane, 2-hydroxyethyltriethoxysilane, 2-hydroxypropyltrimethoxysilane, 2-hydroxypropyltriethoxysilane, 3-hydroxypropyltrimethoxysilane, 3-hydroxypropyltriethoxysilane, 3-mercaptopropyltrimethoxysilane, 3-mercaptopropyltriethoxysilane, 3-isocyanatepropyltrimethoxysilane, 3-isocyanatepropyltriethoxysilane, 3-(meta) acryloxypropyltrimethoxysilane, 3-(meta) acryloxypropyltriethoxysilane, 3-ureidopropyltrimethoxysilane, and 3-ureidopropyltriethoxysilane; and dialkoxysilanes such as dimethyldimethoxysilane, dimethyldiethoxysilane, diethyldimethoxysilane, diethyldiethoxysilane, di-n-propyldimethoxysilane, di-n-propyldiethoxysilane, di-i-propyldimethoxysilane, di-i-propyldiethoxysilane, di-n-butyldimethoxysilane, di-n-butyldiethoxysilane, di-n-pentyldimethoxysilane, di-n-pentyldiethoxysilane, di-n-hexyldimethoxysilane, di-n-hexyldiethoxysilane, di-n-heptyldimethoxysilane, di-n-heptyldiethoxysilane, di-n-octyldimethoxysilane, di-n-octyldiethoxysilane, di-n-cyclohexyldimethoxysilane, di-n-cyclohexyldiethoxysilane, diphenyldimethoxysilane, and diphenyldiethoxysilane. One of these alkoxysilanes may be used or two or more of them may be used together. As the alkoxysilane, particularly, tetramethoxysilane and trimethoxymethylsilane are preferable. As the organopolysiloxane, particularly, polydimethylsiloxane and polydiphenyldimethylsiloxane are preferable. A combination of the above preferable alkoxysilane and the above preferable organopolysiloxane can produce, suitably, polydimethylsiloxane or polydiphenyldimethylsiloxane which is terminally modified with methoxysilane.

Suitable examples of the hydrolytic condensate of the alkoxysilane include polymethylsilicate, polyethylsilicate, polypropoxysilicate, and polybutoxy silicate. One of these hydrolytic condensates of alkoxysilane may be used or two or more of them may be used together. As the hydrolytic condensate of alkoxysilane, particularly, ethylsilicate is preferable. As the organopolysiloxane, polydimethylsiloxane and polydiphenyldimethylsiloxane are preferable, as mentioned above.

Examples of the metal substrate 10 are not limited to the aluminum substrate described above, and another conductive substrate may be used, examples of which include a metal substrate, such as copper and SUS steel, and a carbon substrate. Moreover, the ceramic particles are not limited to the above-described alumina particles 28a and may be another ceramic material such as AlN, MgO, SiC, etc.

Embodiment 2

In the following, Embodiment 2 of the present invention is described. In the present embodiment, the method of fabricating the metal core substrate illustrated in [2. Method for Fabricating Metal Core Substrate] in Embodiment 1, in which (2) a plasma electrolytic oxidation film is formed on a metal substrate and then a sealing process by electrophoretic deposition is performed, is described in detail.

Referring to FIGS. 27 to 32, the fabrication method in which a plasma electrolytic oxidation film is formed on a metal substrate and a sealing process is performed by electrophoretic deposition is described.

FIG. 27 is a diagram illustrating a plasma electrolytic oxidation (PEO) apparatus according to the present embodiment. FIG. 28 is a diagram illustrating characteristics of a PEO film according to the present embodiment.

The plasma electrolytic oxidation (PEO) is a technique involving generating plasma in an aqueous solution to electrically breakdown a thin oxide layer having an aluminum surface by microarc and form a new oxide layer.

As illustrated in FIG. 27, a PEO apparatus 50 includes an anode electrode 55a configured of an aluminum substrate, a cathode electrode 55b, and a power supply 58. For example, 600 V is applied between the anode electrode 55a and the cathode electrode 55b. Note that, according to the electrophoretic deposition described above, about 40 V is applied between the aluminum substrate 10a and the SUS substrate 10b.

The hardness, corrosion resistance, heat resistance, and electrical insulating properties of a metal substrate subjected to the plasma electrolytic oxidation are high like ceramics, as compared to a metal substrate without the plasma electrolytic oxidation. As illustrated in FIG. 28, the hardness of an aluminum substrate without PEO is 30 to 100 Hv, whereas the hardness of a substrate subjected to PEO is 800 to 1400 Hv.

The corrosion resistance (salt spray corrosion resistance) of the aluminum substrate without PEO is about 100 hours, whereas the corrosion resistance of the substrate subjected to PEO is about 5000 hours.

Instant heat resistance of the aluminum substrate without PEO is about 640 degrees Celsius, whereas instant heat resistance of the substrate subjected to PEO is about 2000 degrees Celsius.

An electrical insulating property of the aluminum substrate without PEO is 0, whereas an electrical insulating property of the substrate subjected to PEO is 2.5 kV when the thickness is 50 $\mu$m.

Thus, the plasma electrolytic oxidation film (PEO film) formed by PEO is an oxide layer that is highly abrasion resistant and corrosion resistant.

However, the PEO film, despite of the high mechanical strength, is made porous due to a gas generated during deposition. Thus, the surface roughness may be great and the electrical insulating properties may be poor. Specifically, the PEO film has a thermal conductivity of 1 W/mK or less and a dielectric withstand voltage of 2.5 kV or less. Thus, in order to use the PEO film for an electronic circuit board substrate, it is advantageous to perform a sealing process of forming an electrophoretic deposition film on the plasma electrolytic oxidation film. The sealing process enhances the thermal conduction characteristic and the electrical insulating properties.

The electrophoretic deposition described above is used to form the electrophoretic deposition film. To be more specific, an electrophoretic deposition film is formed on the PEO film, using the aluminum substrate 10a in FIG. 3A as an aluminum substrate having the PEO film formed thereon. Conditions for the electrophoretic deposition are using

constant current and adjusting the electrophoretic deposition time as appropriate, so that the electrophoretic deposition film has a thickness of 50 μm, for example. After forming the electrophoretic deposition film having the thickness of 50 μm, the electrophoretic deposition film is heat treated at 250 degrees Celsius for 2 hours to obtain an electrocoating cured film. Thus results in an electrophoretic deposition film cured product.

FIG. 29A is a diagram illustrating the surface of the PEO film prior to the sealing process according to the embodiment. FIGS. 29B and 29C are diagrams illustrating the surfaces of the PEO film after the sealing process according to the embodiment.

As illustrated in FIG. 29A, the PEO film prior to the sealing process achieves a much dense layer, as compared to an anodized film, but has a rough surface due to pores. In contrast, as illustrated in FIG. 29B, pores in the PEO film are sealed after the sealing process in which the electrophoretic deposition film having the thickness of 5 μm is formed on the surface of the PEO film using an electrophoretic deposition fluid containing 5 parts by weight of ES and 15 parts by weight of PDMS-B, and the roughness of the surface of the PEO film is mild, as compared to FIG. 29A. Moreover, as illustrated in FIG. 29C, pores in the PEO film are sealed after the sealing process in which an electrophoretic deposition film having a thickness of 10 μm is formed on the surface of the PEO film, and the roughness of the surface of the PEO film is further mild, as compared to FIGS. 29A and 29B. Thus, it can be seen that the sealing process can eliminate pores in the surface of the PEO film and smooth the surface.

Next, electrical breakdown strength, electrical insulating characteristic, and heat conduction characteristic that are obtained through the sealing process are described. FIG. 30 is a diagram illustrating the electrical breakdown strength of each film according to the embodiment. FIG. 31 is a diagram illustrating the thermal conductivity and dielectric withstand voltage of each film according to the embodiment. FIG. 32 shows diagrams illustrating the thermal conductivity before and after the sealing process according to the embodiment.

Initially, electrical insulating characteristic of the PEO film obtained through the sealing process is described.

FIG. 30 illustrates electrical breakdown strengths of the PEO film having a thickness of 50 μm, a film in which the electrophoretic deposition film having a thickness of 13 μm is formed on the PEO film having a thickness of 50 μm, and the electrophoretic deposition film, only, which has a thickness of 35 μm. As illustrated in FIG. 30, forming the electrophoretic deposition film on the PEO film increases the electrical breakdown strength.

FIG. 31 illustrates the dielectric withstand voltage and the thermal conductivity of each of the films illustrated in FIG. 30 ("PEO film (the PEO film having the thickness of 50 μm)," "electrophoretic deposition film according to the present technology (the electrophoretic deposition film only which has the thickness of 35 μm)," and "PEO film sealed with electrophoretic deposition film (the film in which the electrophoretic deposition film having the thickness of 13 μm is formed on the PEO film having the thickness of 50 μm)"). As illustrated in FIG. 31, the thermal conductivity of the "PEO film" is 0.89 W/mK, the thermal conductivity of the "electrophoretic deposition film according to the present technology" is 2.56 W/mK, and the thermal conductivity of the "PEO film sealed with electrophoretic deposition film" is 1.71 W/mK. This means that the thermal conductivity after micropores in the PEO film are sealed is increased by about 10% (this is described below, with reference to FIG. 32). Moreover, the dielectric withstand voltage after micropores in the PEO film is sealed is 3.8 kV, and the shared voltage of the PEO film during application of a breakdown voltage is estimated to be 3.1 kV, with assumption that the dielectric constant of the electrophoretic deposition film does not differ from that of the PEO film. Thus, it can be seen that the sealing process increases the electric strength of the PEO film by 25%, as compared to 2.5 kV of dielectric withstand voltage of the PEO film prior to the sealing process.

Next, effects of the sealing process in improving the heat conduction characteristic of the PEO film are described.

The thermal conductivity of the PEO film prior to the sealing process is 0.89 W/mK (see FIG. 31) whereas the thermal conductivity of the entirety of the PEO film having the electrophoretic deposition film formed thereon by the sealing process is 1.71 W/mK (see FIG. 31). In view of this, the thermal conductivity of the PEO film after the sealing process is 0.98 W/mK and the thermal conductivity of the electrophoretic deposition film is 2.54 W/mK, as illustrated in FIG. 32. Thus, it can be seen that the thermal conductivity of the PEO layer increases by 10% by sealing micropores in the PEO film.

From the above, the heat resistance and stress relaxation property to a temperature change of the metal core substrate 1 can be improved by forming a plasma electrolytic oxidation film on the metal substrate and then sealing micropores in the plasma electrolytic oxidation film.

As described above, according to the metal core substrate of the present embodiment, an electrical-insulation heat-dissipation substrate that has high heat resistance and more excellent thermal shock resistance can be formed by forming the PEO film and then performing the sealing process.

For example, while the embodiments have been described with reference to the binder material, which is added to the electrophoretic deposition fluid, being the organopolysiloxane-based organic-inorganic hybrid material, the binder material may be an organopolysiloxane composition cured product which contains a polydimethylsiloxane-based organic-inorganic hybrid material.

Moreover, the metal substrate 10 is not limited to the aluminum substrate described above, and another metal substrate or a conductive substrate, such as a carbon substrate, may be used. Moreover, the ceramic particles also are

not limited to the alumina particles described above, and may be another ceramic material.

Moreover, the blending of the materials comprising the electrophoretic deposition fluid is not limited to 15 wt% of alpha alumina, 12.75 wt% of MCAA, and 72.25 wt% of the dry IPA as described above, and may be a different blending.

Further, the above embodiments may be combined

[Industrial Applicability]

The metal core substrate is applicable to devices and apparatuses that require high heat resistance, thermal shock resistance, and high electrical insulating properties, such as an inverter substrate, headlight light source, fast charger, heat pump air conditioner, solar and thermal components, etc., for example.

[Reference Signs List]

1 metal core substrate
2 circuit board
10 metal substrate (aluminum substrate)
10a electrode (aluminum substrate)
10b electrode (SUS substrate)
12 electrical insulating layer (electrophoretic depositionfilm)
14 interconnect layer
20 electrodeposition device
22 container
26, 48, 58 power supply
28 electrodeposition fluid
28a alumina particles (ceramic particles)
28b binder
29 silica nanoglass
30 evaluation device
31 thermal insulating material
32 heater
34 aluminum block
36 sample
38 air cooling fin
40 evaluation device for breakdown field strength
42 lower electrode
44 measurement specimen
46 upper electrode
50 PEO apparatus
55a anode electrode
55b cathode electrode

## Claims

1. An electrophoretic deposition fluid including ceramic particles (28a) and a binder raw material (28b), for use in electrophoretic deposition, **characterized in that** the binder raw material (28b) is an organopolysiloxane composition including at least one of: polydialkylsiloxane terminally modified with metal alkoxide; polydiarylsiloxane terminally modified with metal alkoxide; and polyalkylarylsiloxane terminally modified with metal alkoxide, wherein
the metal alkoxide with which the polydialkylsiloxane is terminally modified, the metal alkoxide with which the polydiarylsiloxane is terminally modified, and the metal alkoxide with which polyalkylarylsiloxane is terminally modified are each a metal alkoxide or a hydrolytic condensate of the metal alkoxide.

2. The electrophoretic deposition fluid according to claim 1, wherein
the electrophoretic deposition fluid further includes metal alkoxide or a hydrolytic condensate of the metal alkoxide.

3. The electrophoretic deposition fluid according to claim 1 or claim 2, wherein

the organopolysiloxane composition has a molecular weight of at least 8000 and of less than 80000, and the organopolysiloxane composition is a polydimethylsiloxane terminally modified with ethylsilicate.

**4.** A method for fabricating a metal core substrate, the method including:

obtaining an electrophoretic deposition fluid by mixing, into a solution consisting in a mixture of dehydrated isopropyl alcohol 'IPA' and monochloroacetic acid 'MCAA', ceramic particles (28a) and a binder raw material (28b) which binds the ceramic particles (28a);
forming an electrophoretic deposition film including the ceramic particles (28a) and the binder raw material (28b), on a surface of a metal substrate (10) immersed in the electrophoretic deposition fluid, by electrophoretic deposition using the electrophoretic deposition fluid; and
curing the binder raw material (28b) of the electrophoretic deposition film by subjecting the binder raw material (28b) to hydrolytic polycondensation, wherein
the method is **characterized in that** the binder raw material (28b) is an organopolysiloxane composition including at least one of: polydialkylsiloxane terminally modified with metal alkoxide; polydiarylsiloxane terminally modified with metal alkoxide; and polyalkylarylsiloxane terminally modified with metal alkoxide, wherein
the metal alkoxide with which the polydialkylsiloxane is terminally modified, the metal alkoxide with which the polydiarylsiloxane is terminally modified, and the metal alkoxide with which polyalkylarylsiloxane is terminally modified are each a metal alkoxide or a hydrolytic condensate of the metal alkoxide.

**5.** The method for fabricating a metal core substrate according to claim 4, wherein a surface of the metal substrate is subjected to plasma electrolytic oxidation before performing the electrophoretic film deposition and wherein the metal substrate is an aluminum substrate.

## Patentansprüche

**1.** Elektrophoretische Tauchflüssigkeit, die Keramikteilchen (28a) und ein Bindemittel-Rohmaterial (28b) enthält, zur Verwendung bei der elektrophoretischen Abscheidung,
**dadurch gekennzeichnet, dass** das Bindemittel-Rohmaterial (28b) eine Organopolysiloxan-Zusammensetzung ist, die mindestens eines von Folgendem enthält: Polydialkylsiloxan, das endständig mit Metallalkoxid modifiziert ist; Polydiarylsiloxan, das endständig mit Metallalkoxid modifiziert ist; und Polyalkylarylsiloxan, das endständig mit Metallalkoxid modifiziert ist, wobei
das Metallalkoxid, mit dem das Polydialkylsiloxan endständig modifiziert ist, das Metallalkoxid, mit dem das Polydiarylsiloxan endständig modifiziert ist, und das Metallalkoxid, mit dem Polyalkylarylsiloxan endständig modifiziert ist, jeweils ein Metallalkoxid oder ein hydrolytisches Kondensat des Metallalkoxids sind.

**2.** Elektrophoretische Tauchflüssigkeit nach Anspruch 1, wobei
die elektrophoretische Tauchflüssigkeit weiterhin Metallalkoxid oder ein hydrolytisches Kondensat des Metallalkoxids enthält.

**3.** Elektrophoretische Tauchflüssigkeit nach Anspruch 1 oder Anspruch 2, wobei
die Organopolysiloxan-Zusammensetzung ein Molekulargewicht von mindestens 8000 und von weniger als 80000 aufweist, und
die Organopolysiloxan-Zusammensetzung ein Polydimethylsiloxan ist, das endständig mit Ethylsilikat modifiziert ist.

**4.** Verfahren zum Herstellen eines Metallkernsubstrats, wobei das Verfahren Folgendes umfasst:

Erhalten einer elektrophoretischen Tauchflüssigkeit durch Mischen von Keramikteilchen (28a) und einem Bindemittel-Rohmaterial (28b), das die Keramikteilchen (28a) bindet, in eine Lösung, die aus einer Mischung aus dehydriertem Isopropylalkohol 'IPA' und Monochloressigsäure 'MCAA' besteht;
Ausbilden eines elektrophoretischen Abscheidungsfilms, der die Keramikteilchen (28a) und das Bindemittel-Rohmaterial (28b) enthält, auf einer Oberfläche eines Metallsubstrats (10), das in die elektrophoretische Tauchflüssigkeit eingetaucht ist, durch elektrophoretische Abscheidung unter Verwendung der elektrophoretischen Tauchflüssigkeit; und
Härten des Bindemittel-Rohmaterials (28b) des elektrophoretischen Abscheidungsfilms durch Unterziehen des Bindemittel-Rohmaterials (28b) einer hydrolytischen Polykondensation, wobei
das Verfahren **dadurch gekennzeichnet ist, dass** das Bindemittel-Rohmaterial (28b) eine Organopolysiloxan-Zusammensetzung ist, die mindestens eines von Folgendem enthält: Polydialkylsiloxan, das endständig mit Metallalkoxid modifiziert ist; Polydiarylsiloxan, das endständig mit Metallalkoxid modifiziert ist; und Polyalkylarylsiloxan, das endständig mit Metallalkoxid modifiziert ist, wobei
das Metallalkoxid, mit dem das Polydialkylsiloxan endständig modifiziert ist, das Metallalkoxid, mit dem das Polydiarylsiloxan endständig modifiziert ist, und das Metallalkoxid, mit dem Polyalkylarylsiloxan endständig modifiziert ist, jeweils ein Metallalkoxid oder ein hydrolytisches Kondensat des Metallalkoxids sind.

**5.** Verfahren zur Herstellung eines Metallkernsubstrats nach Anspruch 4,
wobei eine Oberfläche des Metallsubstrats vor der Durchführung der elektrophoretischen Filmabscheidung einer plasmaelektrolytischen Oxidation unterzogen wird und
wobei das Metallsubstrat ein Aluminiumsubstrat ist.

## Revendications

**1.** Fluide de déposition électrophorétique contenant des particules de céramique (28a) et une matière première de liant (28b), pour une utilisation dans une déposition électrophorétique,
**caractérisé en ce que** la matière première de liant (28b) est une composition d'organopolysiloxane contenant au moins l'un parmi : un polydialkylsiloxane modifié en position terminale par un alkoxyde métallique ; un polydiarylsiloxane modifié en position terminale par un alkoxyde métallique ; et un polyalkylarylsiloxane modifié en position terminale par un alkoxyde métallique, dans lequel
chacun parmi l'alkoxyde métallique par lequel le polydialkylsiloxane est modifié en position terminale, l' alkoxyde métallique par lequel le polydiarylsiloxane est modifié en position terminale, et l' alkoxyde métallique par lequel le polyalkylarylsiloxane est modifié en position terminale, est un alkoxyde métallique ou un condensat hydrolytique de l' alkoxyde métallique.

**2.** Fluide de déposition électrophorétique selon la revendication 1, lequel fluide de déposition électrophorétique contient en outre un alkoxyde métallique ou un condensat hydrolytique de l' alkoxyde métallique.

**3.** Fluide de déposition électrophorétique selon la revendication 1 ou la revendication 2, dans lequel
la composition d'organopolysiloxane a une masse moléculaire d'au moins 8 000 et inférieure à 80 000, et
la composition d'organopolysiloxane est un polydiméthylsiloxane modifié en position terminale par du silicate d'éthyle.

**4.** Procédé pour fabriquer un substrat à noyau métallique, le procédé comprenant :

l'obtention d'un fluide de déposition électrophorétique par mélange, dans une solution consistant en un mélange d'alcool isopropylique déshydraté "IPA" et d'acide monochloroacétique "MCAA", de particules de céramique (28a) et d'une matière première de liant (28b) qui lie les particules de céramique (28a) ;
la formation d'un film de déposition électrophorétique contenant les particules de céramique (28a) et la matière première de liant (28b), sur une surface d'un substrat métallique (10) immergé dans le fluide de déposition électrophorétique, par déposition électrophorétique utilisant le fluide de déposition électrophorétique ; et
le durcissement de la matière première de liant (28b) du film de déposition électrophorétique par soumission de la matière première de liant (28b) à une polycondensation hydrolytique,
lequel procédé est **caractérisé en ce que** la matière première de liant (28b) est une composition d'organopolysiloxane contenant au moins l'un parmi : un polydialkylsiloxane modifié en position terminale par un alkoxyde métallique ; un polydiarylsiloxane modifié en position terminale par un alkoxyde métallique ; et un polyalkylarylsiloxane modifié en position terminale par un alkoxyde métallique,
dans lequel chacun parmi l'alkoxyde métallique par lequel le polydialkylsiloxane est modifié en position terminale, l'alkoxyde métallique par lequel le polydiarylsiloxane est modifié en position terminale, et l' alkoxyde métallique par lequel le polyalkylarylsiloxane est modifié en position terminale, est un alkoxyde métallique ou un condensat hydrolytique de l'alkoxyde métallique.

**5.** Procédé pour fabriquer un substrat à noyau métallique selon la revendication 4,
dans lequel une surface du substrat métallique est soumise à une oxydation électrolytique par plasma avant la mise en œuvre de la déposition de film électrophorétique, et
dans lequel le substrat métallique est un substrat en aluminium.

FIG. 1

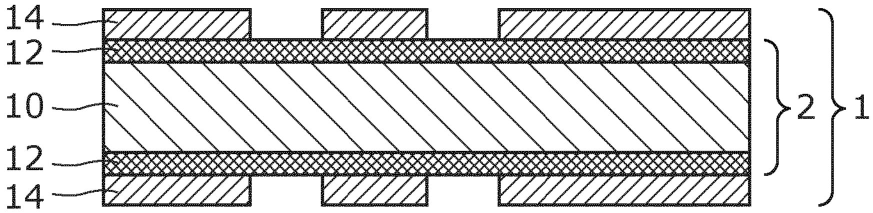

FIG. 2

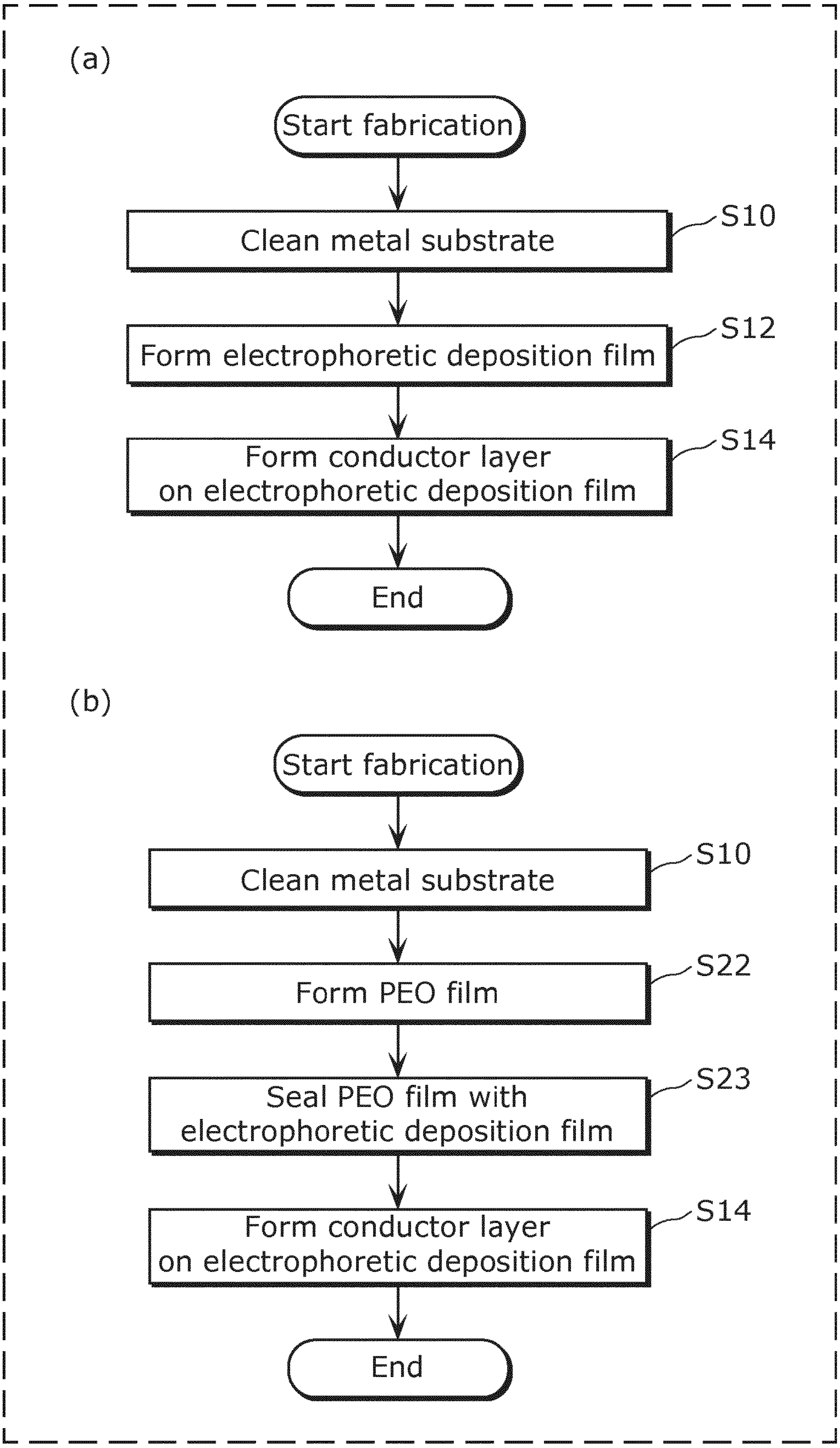
(a)
Start fabrication
Clean metal substrate
S10
Form electrophoretic deposition film
S12
Form conductor layer on electrophoretic deposition film
S14
End
(b)
Start fabrication
Clean metal substrate
S10
Form PEO film
S22
Seal PEO film with electrophoretic deposition film
S23
Form conductor layer on electrophoretic deposition film
S14
End

FIG. 3A

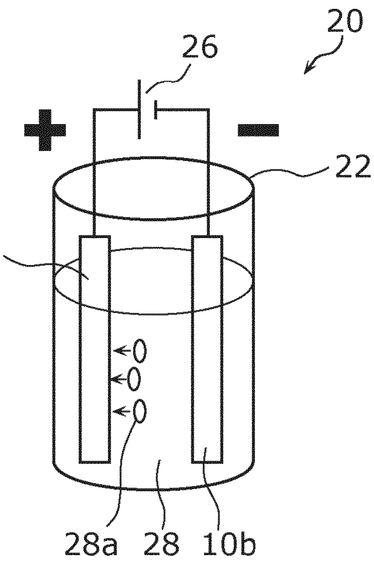


FIG. 3B

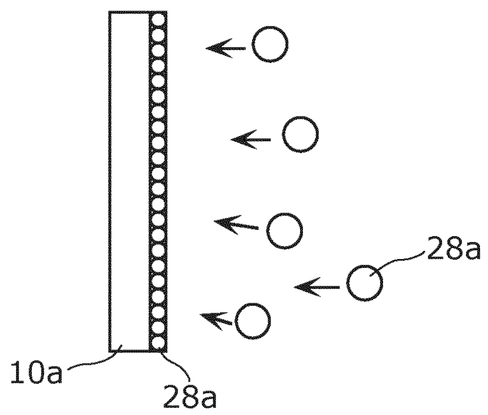


FIG. 4

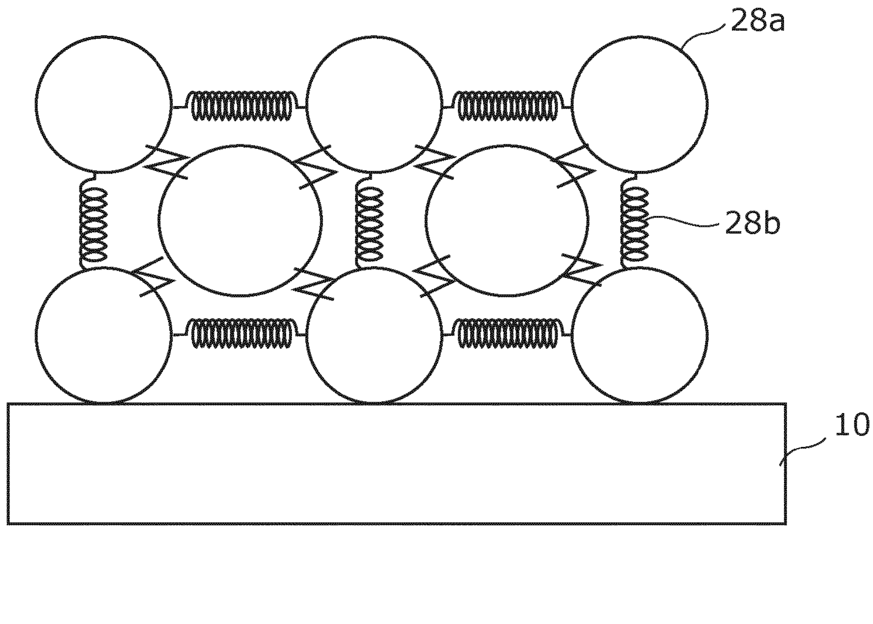

FIG. 5

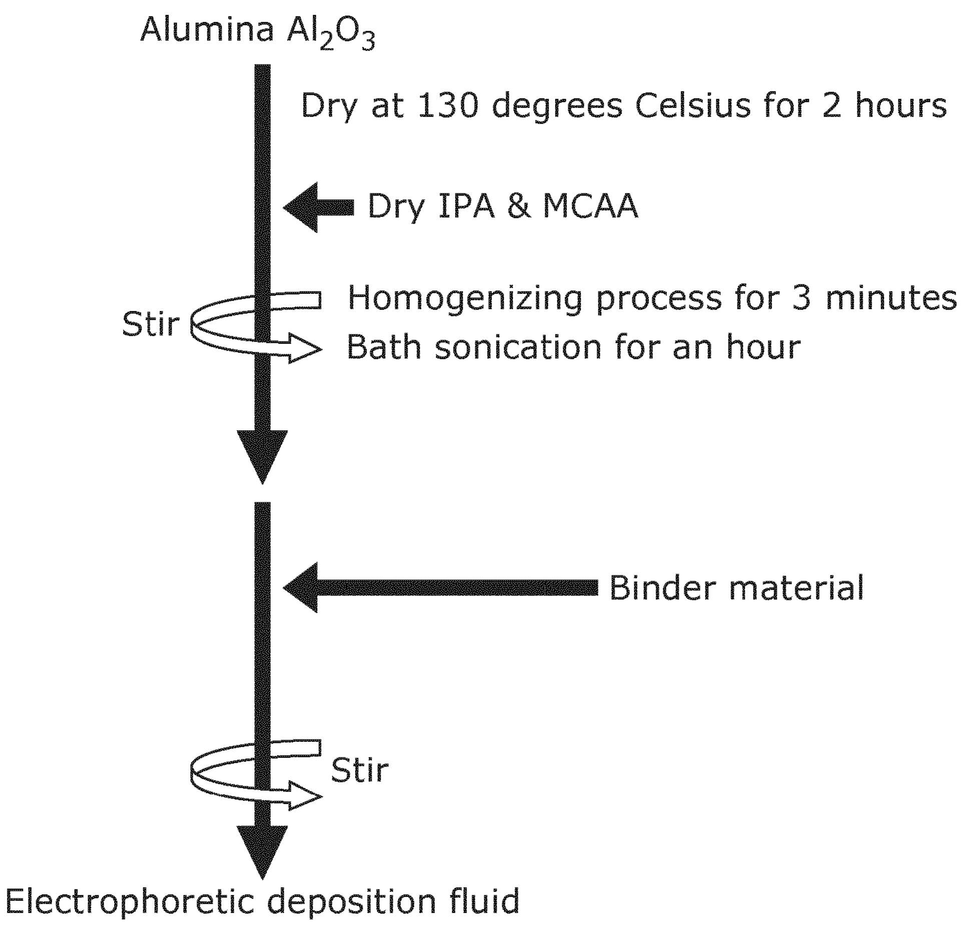
Alumina $Al_2O_3$
Dry at 130 degrees Celsius for 2 hours
Dry IPA & MCAA
Stir
Homogenizing process for 3 minutes
Bath sonication for an hour
Binder material
Stir
Electrophoretic deposition fluid

FIG. 6

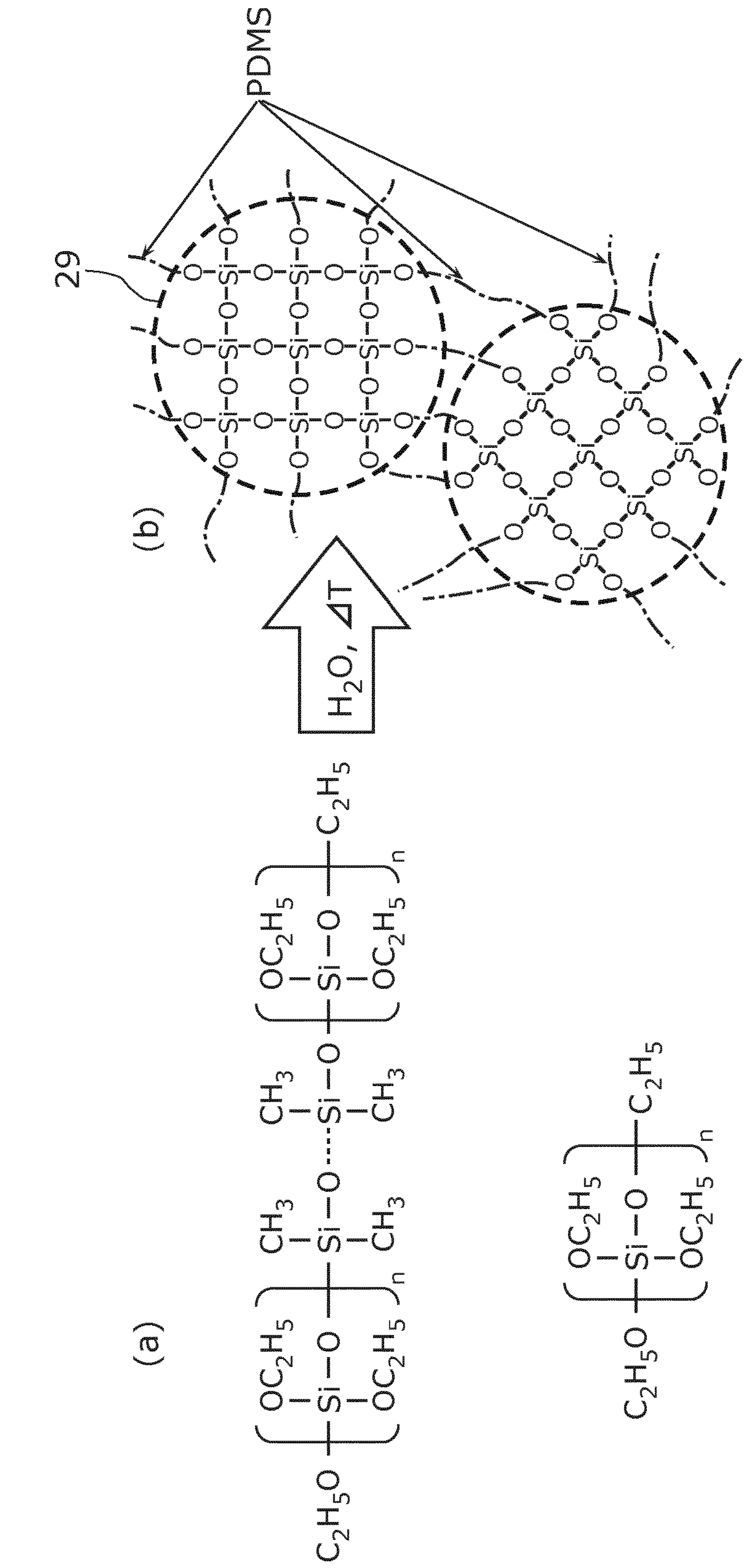

FIG. 7

400-fold

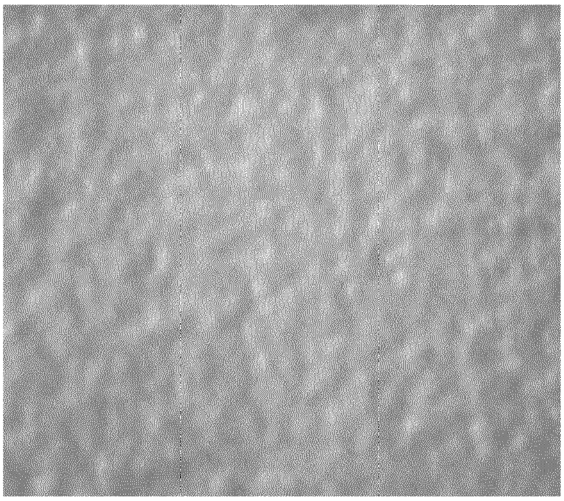

FIG. 8

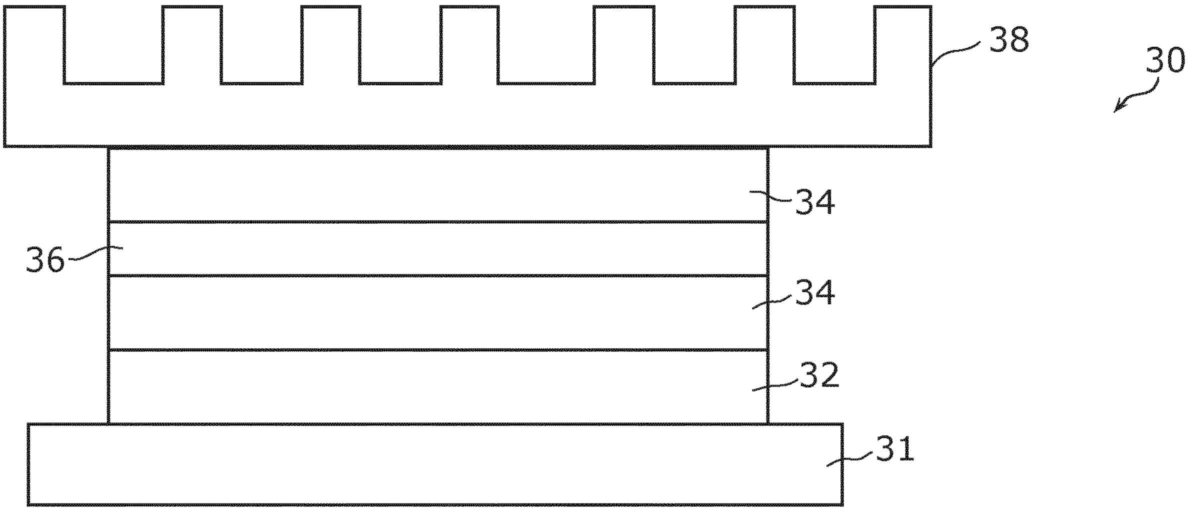

FIG. 9

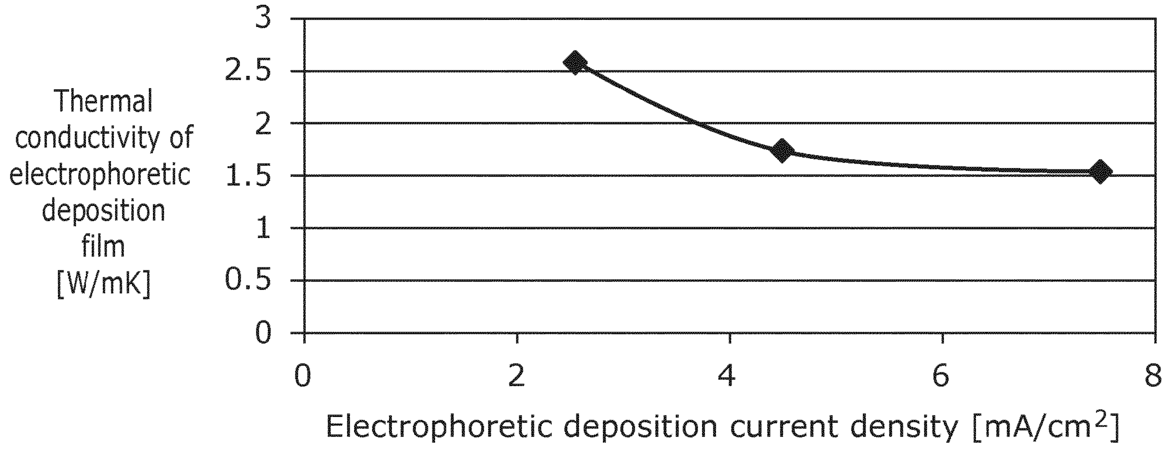


FIG. 10

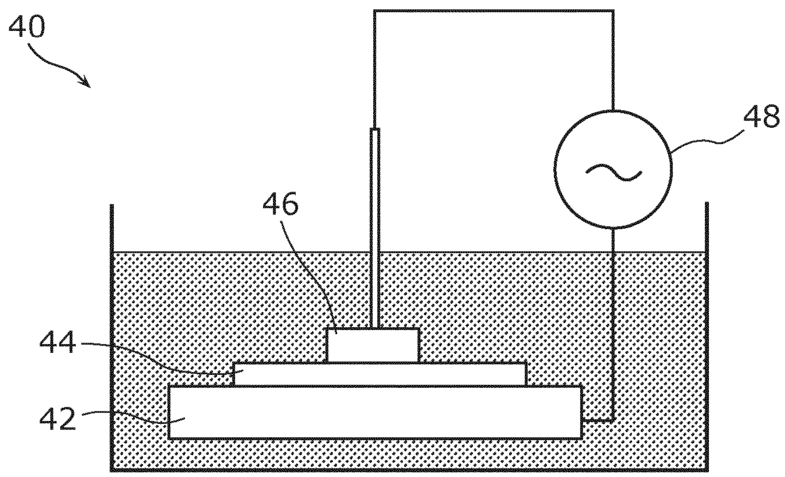


FIG. 11

| Modified PDMS type | ES45 loading (part) | ES -PDMS loading (part) | Hardness [N] | Thermal conductivity [W/mK] | Electrical breakdown strength [kV/mm] |
|---|---|---|---|---|---|
| Molecular weight Mw = 8,000 | 5 | 15 | 2.0 | 2.4 | 76.0 |
| Molecular weight Mw = 8,000 | 5 | 17.5 | 3.3 | 3.1 | 79.5 |
| Molecular weight Mw = 8,000 | 7.5 | 17.5 | 3.5 | 2.2 | 89.1 |
| Molecular weight Mw = 22,000 | 5 | 15 | 2.0 | 2.9 | 97.1 |
| Molecular weight Mw = 42,000 | 5 | 15 | 1.0 | 1.1 | 30.9 |
| Comparative Example (Japanese Unexamined Patent Application Publication No. 2003-209329) | – | – | – | 1.0 | 45 |

FIG. 12

| ES [g] | PDMS [g] Mw = 8,000 | Conditions for electrophoretic deposition : Current [A] | | | |
|---|---|---|---|---|---|
| | | 5 | 7.5 | 10 | 12 |
| 5 | 5 | | × | × | × |
| 5 | 10 | | × | × | △2.5N |
| 5 | 15 | | × | ○2.5N | ○2.5N |

| ES [g] | PDMS [g] Mw = 76,000 | Conditions for electrophoretic deposition : Current [A] | | | |
|---|---|---|---|---|---|
| | | 5 | 7.5 | 10 | 12 |
| 5 | 5 | | △1.2N | △1.0N | △0.8N |
| 5 | 10 | × | △1.5N | △1.0N | |
| 5 | 15 | | × | ○1.5N | ○1.2N |

FIG. 13

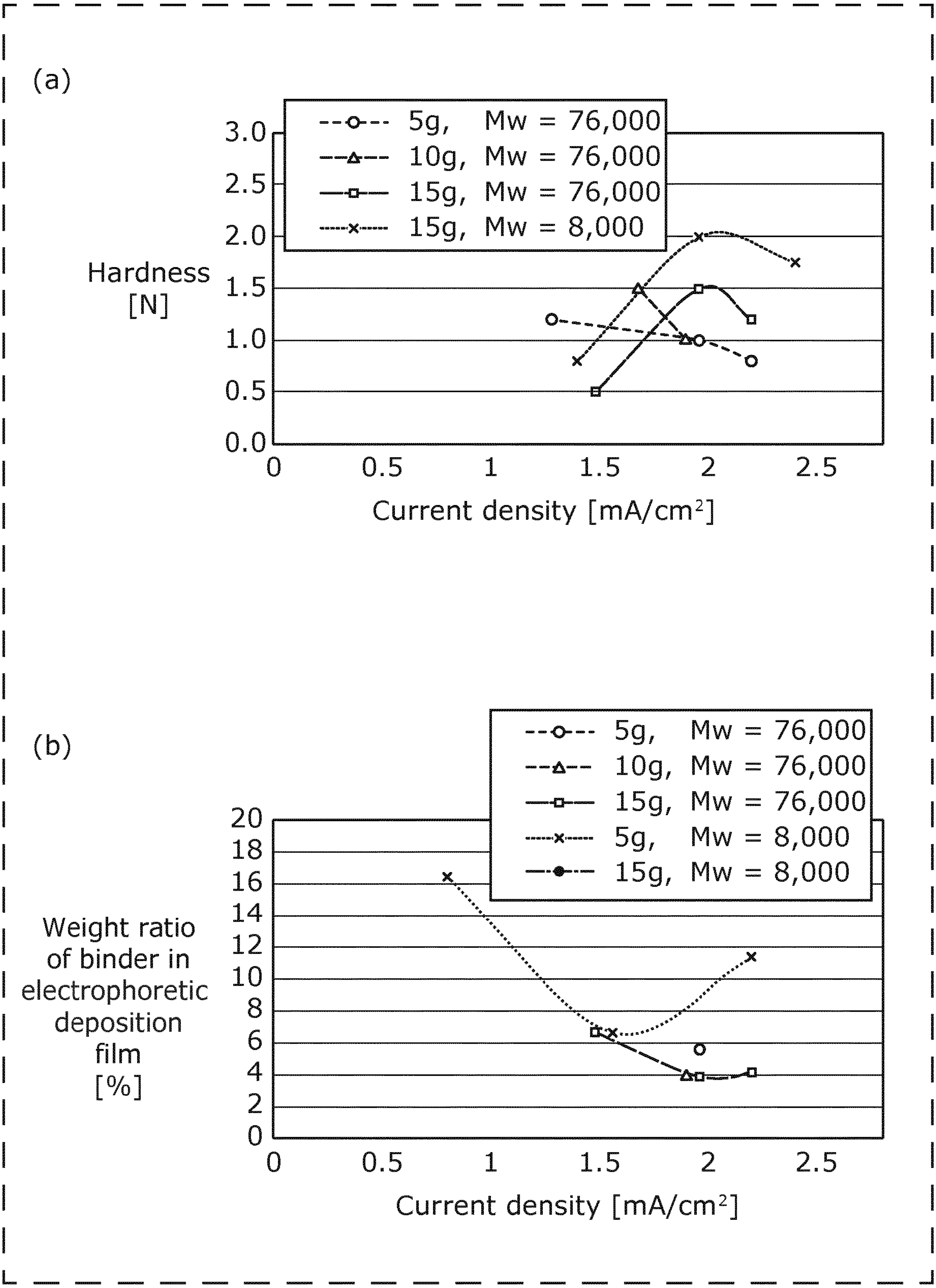
(a)
5g, Mw = 76,000
10g, Mw = 76,000
15g, Mw = 76,000
15g, Mw = 8,000
Hardness [N]
3.0
2.5
2.0
1.5
1.0
0.5
0.0
0
0.5
1
1.5
2
2.5
Current density [mA/cm²]
(b)
5g, Mw = 76,000
10g, Mw = 76,000
15g, Mw = 76,000
5g, Mw = 8,000
15g, Mw = 8,000
Weight ratio of binder in electrophoretic deposition film [%]
20
18
16
14
12
10
8
6
4
2
0
0
0.5
1
1.5
2
2.5
Current density [mA/cm²]

FIG. 14

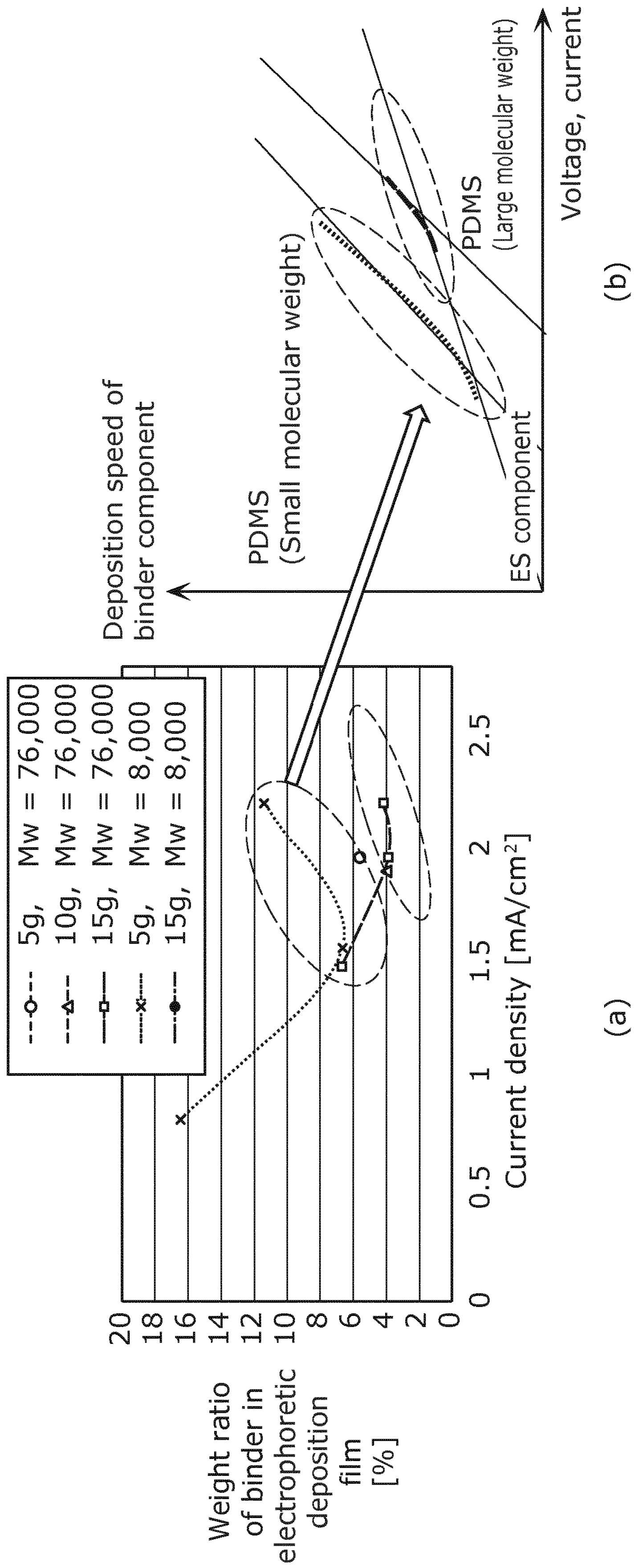
Weight ratio of binder in electrophoretic deposition film [%]
20
18
16
14
12
10
8
6
4
2
0
0
0.5
1
1.5
2
2.5
Current density [mA/cm$^2$]
5g, Mw = 76,000
10g, Mw = 76,000
15g, Mw = 76,000
5g, Mw = 8,000
15g, Mw = 8,000
(a)
Deposition speed of binder component
PDMS (Small molecular weight)
PDMS (Large molecular weight)
ES component
Voltage, current
(b)

FIG. 15

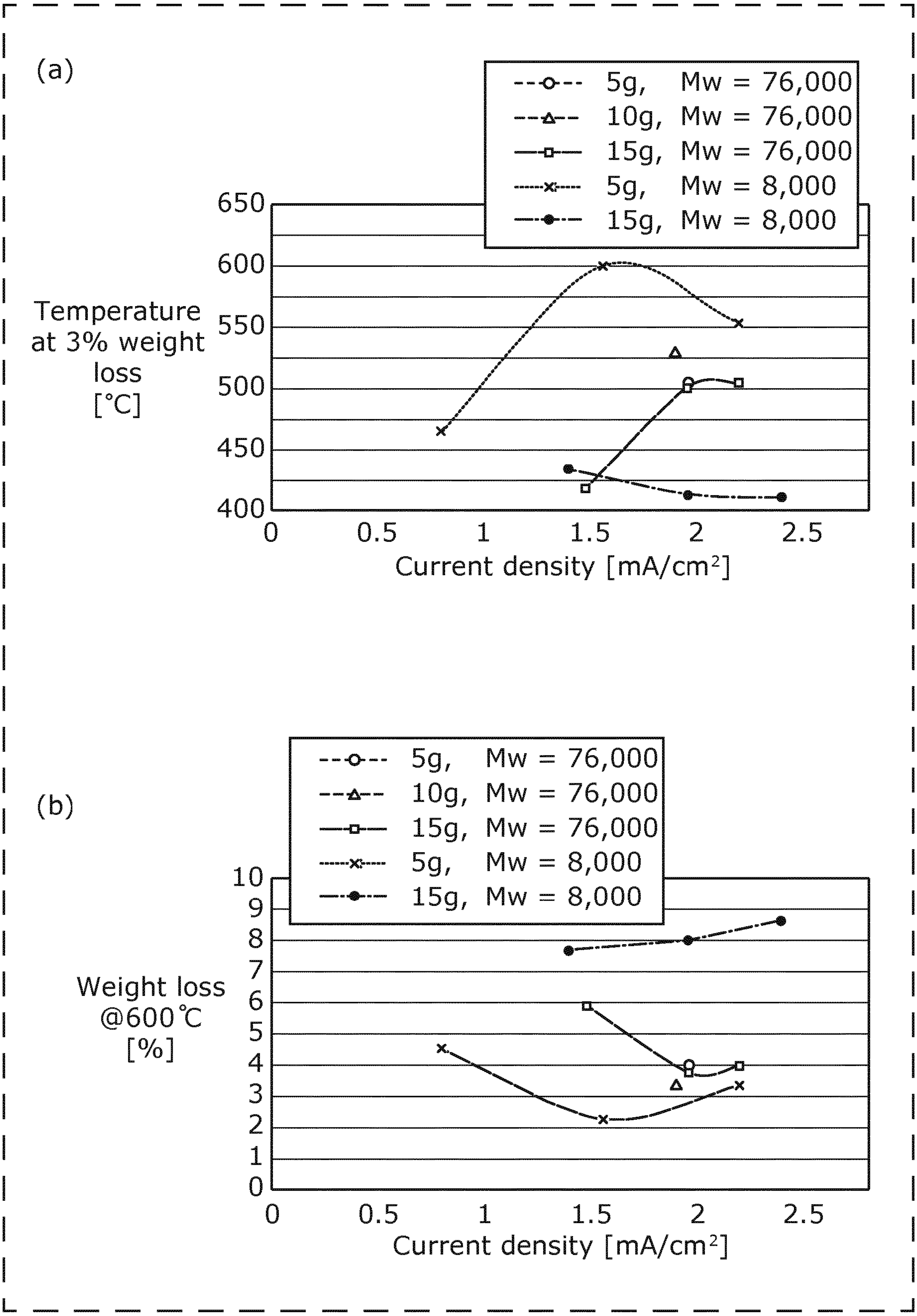
(a)
5g, Mw = 76,000
10g, Mw = 76,000
15g, Mw = 76,000
5g, Mw = 8,000
15g, Mw = 8,000
Temperature at 3% weight loss [°C]
650
600
550
500
450
400
0
0.5
1
1.5
2
2.5
Current density [mA/cm2]
(b)
5g, Mw = 76,000
10g, Mw = 76,000
15g, Mw = 76,000
5g, Mw = 8,000
15g, Mw = 8,000
Weight loss @600℃ [%]
10
9
8
7
6
5
4
3
2
1
0
0
0.5
1
1.5
2
2.5
Current density [mA/cm2]

FIG. 16

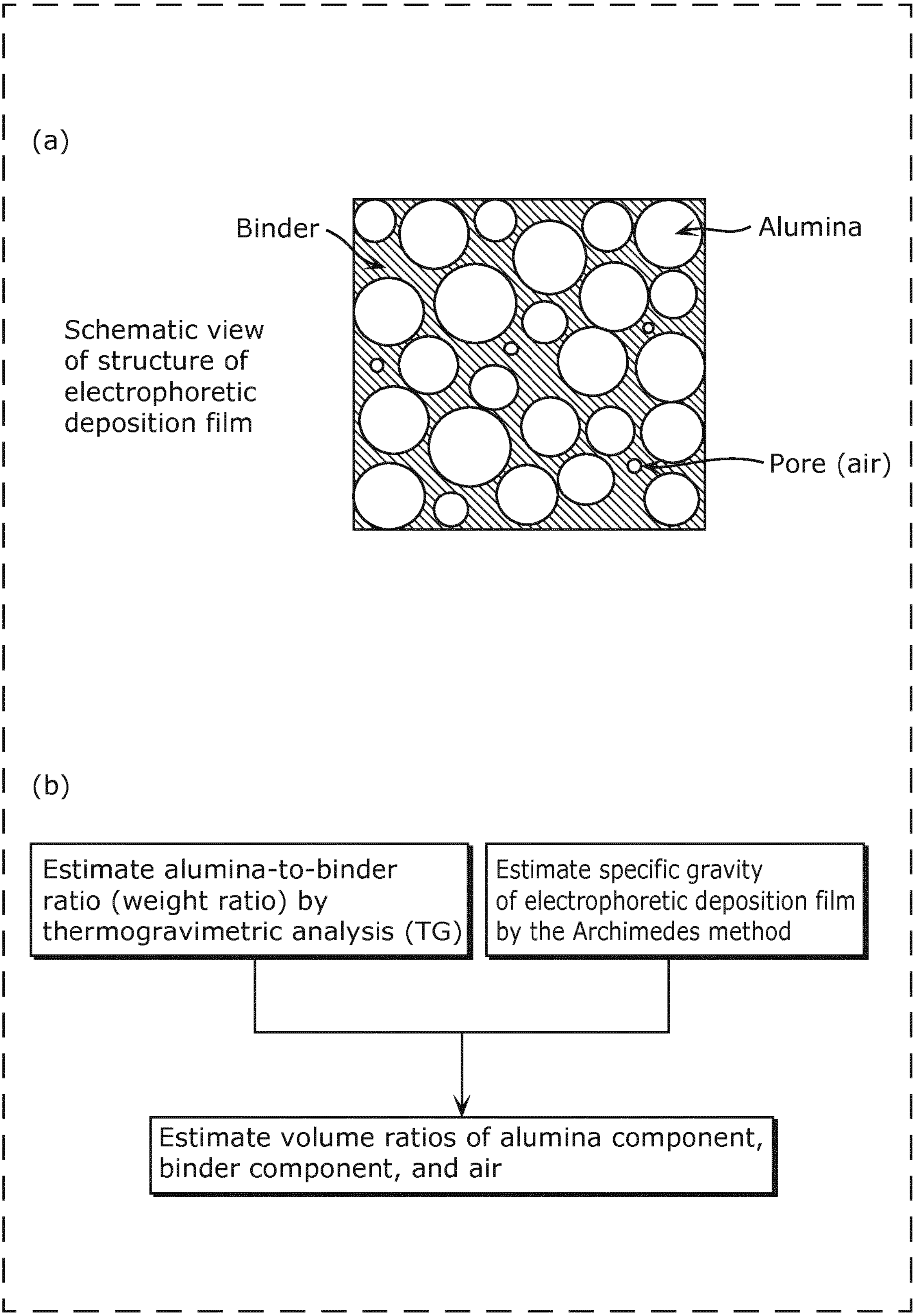
(a)
Binder
Alumina
Schematic view of structure of electrophoretic deposition film
Pore (air)
(b)
Estimate alumina-to-binder ratio (weight ratio) by thermogravimetric analysis (TG)
Estimate specific gravity of electrophoretic deposition film by the Archimedes method
Estimate volume ratios of alumina component, binder component, and air

# FIG. 17

(a)

Estimation of composition (weight ratio) of electrophoretic deposition film by TG

Measure amount of weight loss of each of electrophoretic deposition film comprising alumina and binder, electrophoretic deposition film comprising alumina only (binder-free electrophoretic deposition film), and binder cured product when each is heated up to 1000 degrees Celsius

Thermal weight loss of electrophoretic deposition film (ES : ES-PDMS (Mw = 22,000) = 5 : 15)

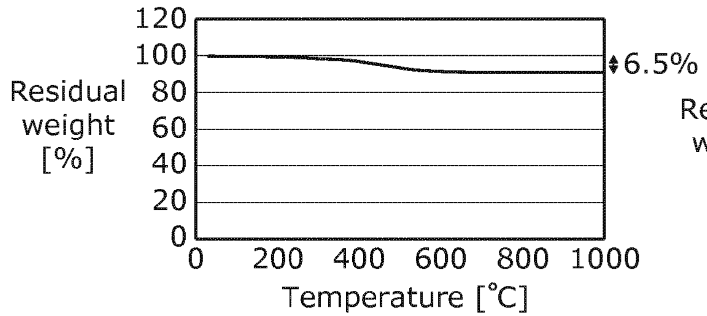


Thermal weight losses of binder-free electrophoretic deposition film and binder cured product

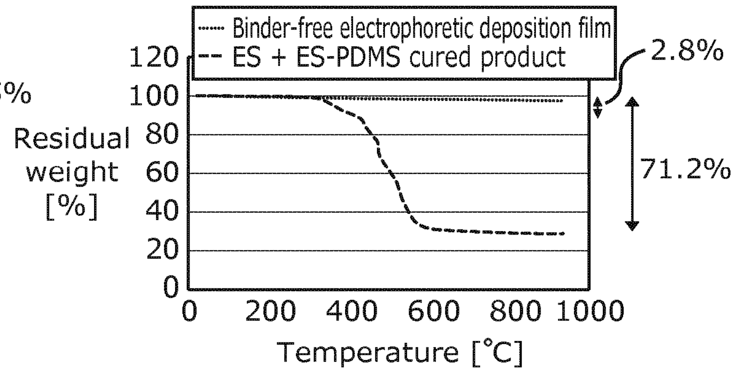


(b)

Estimate weight ratios of alumina and binder from amounts of weight losses calculated

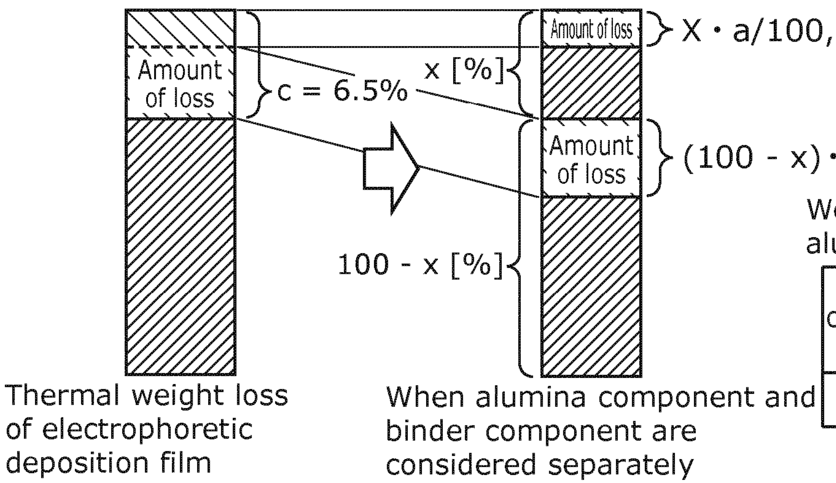


$X \cdot a/100$, $a = 2.8\%$

$(100 - x) \cdot b/100$, $b = 71.2\%$

$$C = ax/100 + (100 - x)b/100$$

$$\Rightarrow x = 100(c - b)/(a - b)$$

Weight ratio of alumina-binder compound

| Alumina component [wt%] | Binder component [wt%] |
|---|---|
| 94.6 | 5.4 |

FIG. 18

(a) Measurement of specific gravity by the Archimedes method

Measurement of specific gravity by the Archimedes method

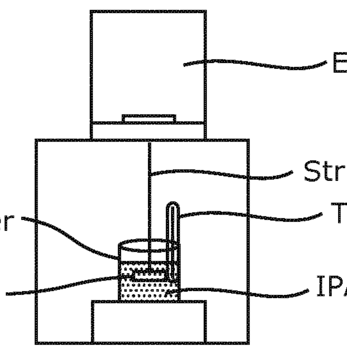


Overview of apparatus for the Archimedes method

Formula for calculating specific gravity

$$ds = \frac{W}{W-W'} d1$$

ds : Specific gravity of object

d1 : Density of liquid bathing the object

W : Mass commensurating with the object weighed in air

W' : Mass commensurating with the object in liquid

For measurement, IPA (ρ = 0.781@25 degrees Celsius) or water (ρ = 0.997@25 degrees Celsius) is used

(b) Specific gravity resulting from the Archimedes method

| | Binder cured product | Electrophoretic deposition film |
|---|---|---|
| Specific gravity [g/m$^3$] | 1.1 | 3.30 ± 0.03 |

FIG. 19

| Material | Weight ratio by TG [wt%] | Specific gravity by the Archimedes method [g/cm$^3$] | Volume ratio [%] |
|---|---|---|---|
| Electrophoretic deposition film | - | 3.3 | 100 |
| Alumina | 94.6 | 4.0 | 77.9 |
| Binder | 5.4 | 1.1 | 16.2 |
| Pore (air) | 0 | 0 | 5.9 |

FIG. 20

(a)

| ES : ES-PDMS (Mw = 6,000) | 5 : 5 | 5 : 10 | 5 : 15 | 5 : 20 |
|---|---|---|---|---|
| Alumina component [wt%] | 92.94 | 87.10 | 79.38 | 75.19 |
| Binder component [wt%] | 7.06 | 12.90 | 20.62 | 24.81 |

(b)

| ES : ES-PDMS (Mw = 6,000) | 5 : 5 | 5 : 10 | 5 : 15 | 5 : 20 |
|---|---|---|---|---|
| Alumina component [vol%] | 78.7 ± 0.3 | 66.4 ± 0.4 | 52.7 ± 0.3 | 46.4 ± 0.8 |
| Binder component [vol%] | 19.9 ± 0.1 | 32.8 ± 0.2 | 45.6 ± 0.3 | 51.1 ± 0.8 |
| Pore component [vol%] | 1.4 ± 0.4 | 0.8 ± 0.6 | 1.7 ± 0.5 | 2.5 ± 1.6 |

(c)

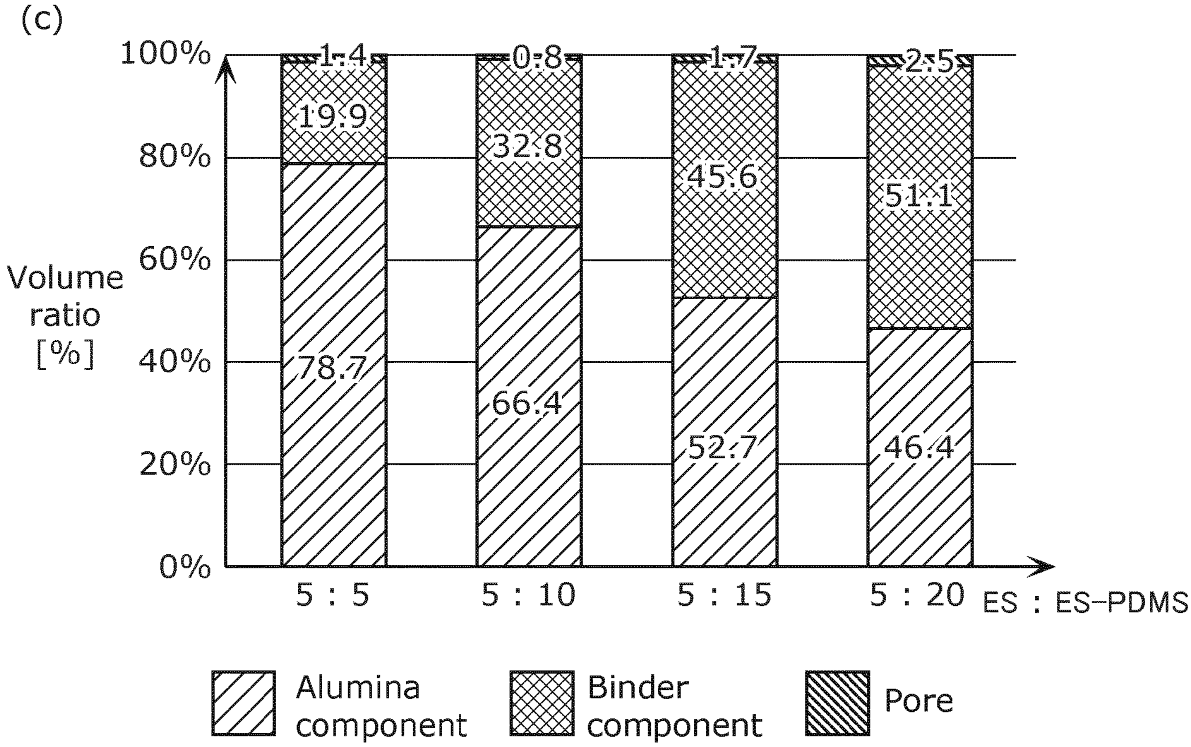

FIG. 21

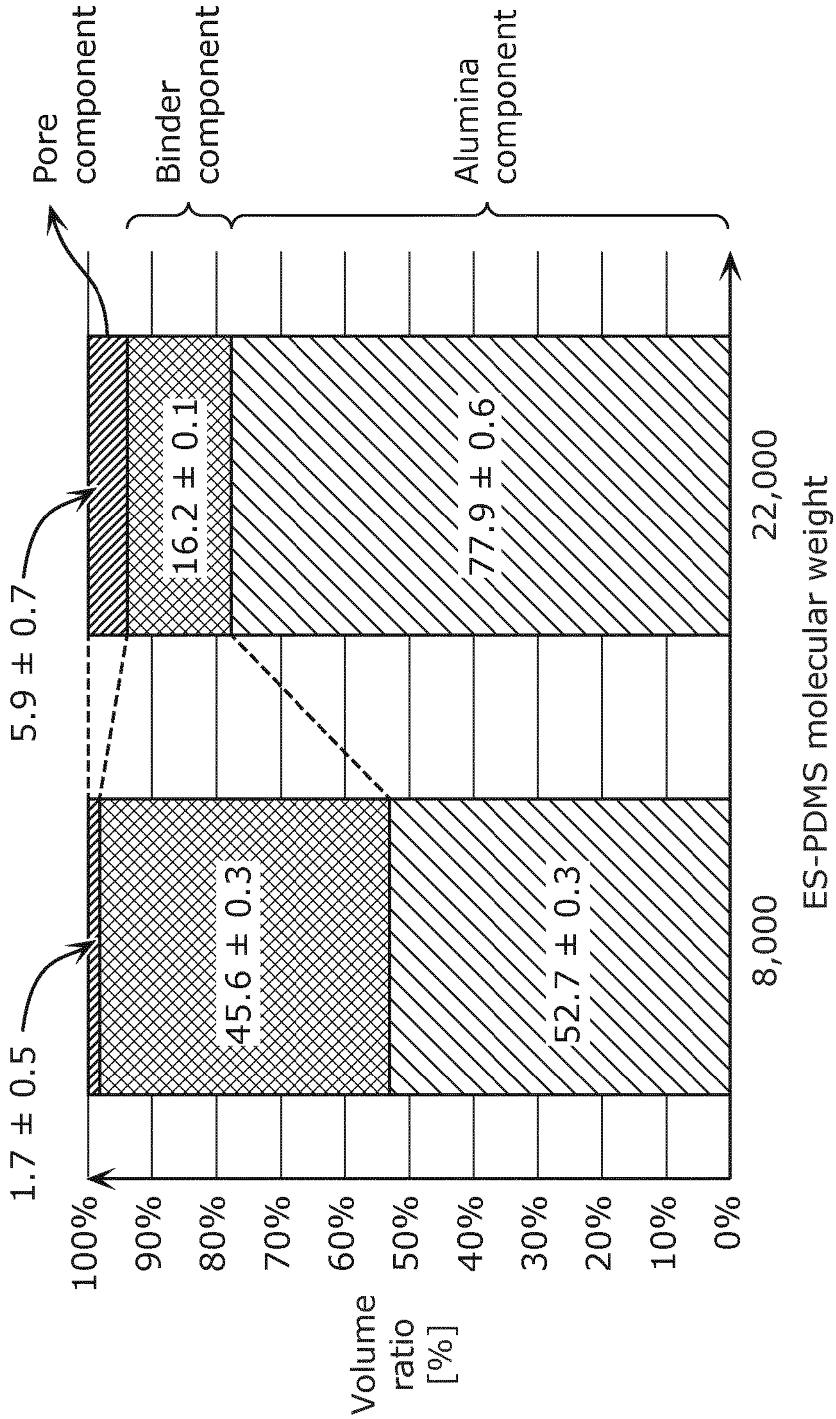
Pore component
Binder component
Alumina component
5.9 ± 0.7
16.2 ± 0.1
77.9 ± 0.6
1.7 ± 0.5
45.6 ± 0.3
52.7 ± 0.3
100%
90%
80%
70%
60%
50%
40%
30%
20%
10%
0%
Volume ratio [%]
8,000
22,000
ES-PDMS molecular weight

FIG. 22

(a)

Bruggeman equation

$$1 - \Phi = \frac{\lambda c - \lambda f}{\lambda m - \lambda f}\left(\frac{\lambda m}{\lambda c}\right)^{1/3}$$

Φ : Volume loading of filler
λc : Thermal conductivity of compound
λf : Thermal conductivity of filler
λm : Thermal conductivity of matrix

(b)

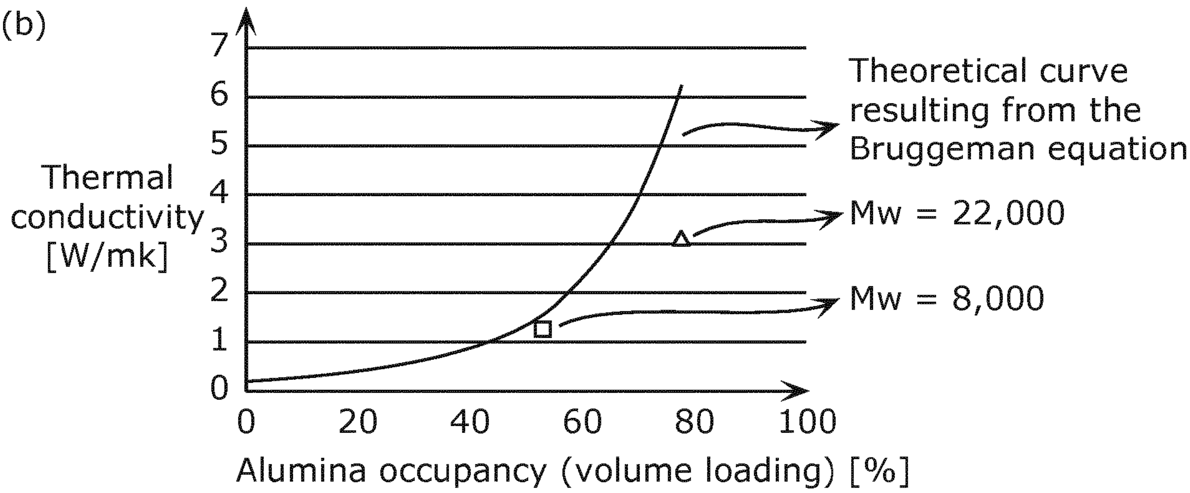


(c)

| ES-PDMS molecular weight Mw | | 8,000 | 22,000 |
|---|---|---|---|
| Alumina occupancy [%] | | 54 | 79 |
| Thermal conductivity [W/mk] | Actual observed value | 1.26 | 3.10 |
| | Estimate from alumina occupancy | 1.53 | 6.27 |

FIG. 23

| ES-PDMS type | ES45 loading (part) | ES -PDMS loading (part) | Hardness [N] | Thermal conductivity [W/mK] | Electrical breakdown strength [kV/mm] | Heat-resistant temperature at 3% weight loss (℃) | Weight ratio of binder component as a percentage of compound (wt%) | Volume ratio (%) | | |
|---|---|---|---|---|---|---|---|---|---|---|
| | | | | | | | | Alumina | Binder | Pore (air) |
| Molecular weight Mw = 8,000 | 5 | 5 | 1.7 | 2.8 | | 560.7 | 7.0 | 65.7 | 29.7 | 4.6 |
| Molecular weight Mw = 8,000 | 5 | 10 | 1.9 | | | 480.0 | 15.3 | 62.9 | 35.4 | 1.7 |
| Molecular weight Mw = 8,000 | 5 | 15 | 2.0 | 2.4 | 76.0 | 427.8 | 25.1 | 46.6 | 52.3 | 1.2 |
| Molecular weight Mw = 8,000 | 5 | 17.5 | 3.3 | 3.1 | 79.5 | ND | ND | | | |
| Molecular weight Mw = 8,000 | 5 | 20 | | | | 399.2 | 27.7 | 44.1 | 55.5 | 0.4 |
| Molecular weight Mw = 8,000 | 7.5 | 17.5 | 3.5 | 2.2 | 89.1 | ND | ND | | | |
| Molecular weight Mw = 22,000 | 5 | 15 | 2.0 | 3.1 | 97.1 | 476.0 | 7.5 | 72.1 | 21.9 | 6.0 |
| Molecular weight Mw = 42,000 | 5 | 15 | 1.0 | 1.1 | 30.9 | ND | ND | ND | ND | ND |
| Molecular weight Mw = 76,000 | 5 | 15 | 1.8 | 2.1 | 32.0 | 505.0 | 27 | 56.3 | 9.6 | 34.1 |

FIG. 24

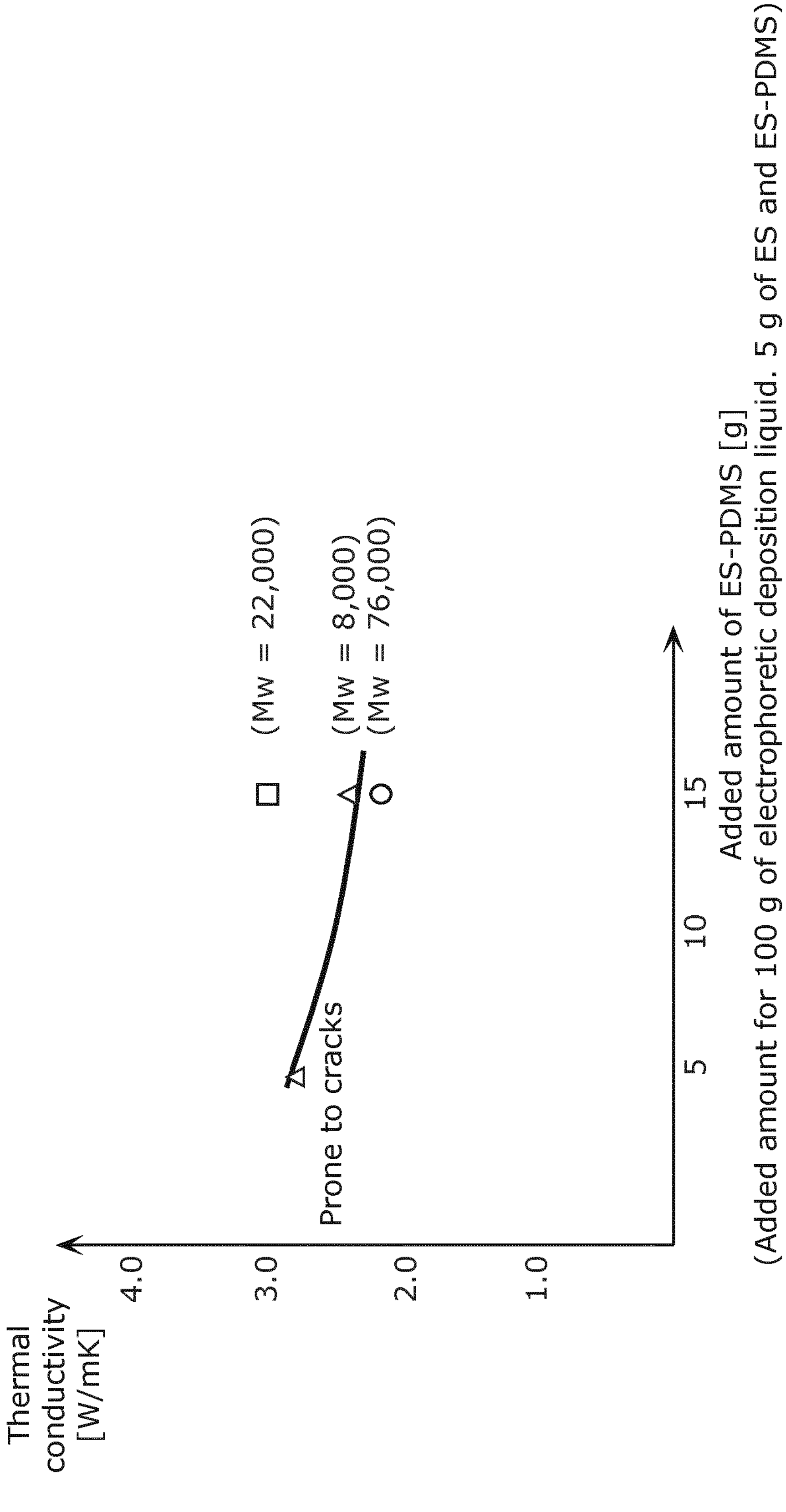
Thermal conductivity [W/mK]
4.0
3.0
2.0
1.0
Prone to cracks
□ (Mw = 22,000)
△ (Mw = 8,000)
○ (Mw = 76,000)
5
10
15
Added amount of ES-PDMS [g]
(Added amount for 100 g of electrophoretic deposition liquid. 5 g of ES and ES-PDMS)

FIG. 25

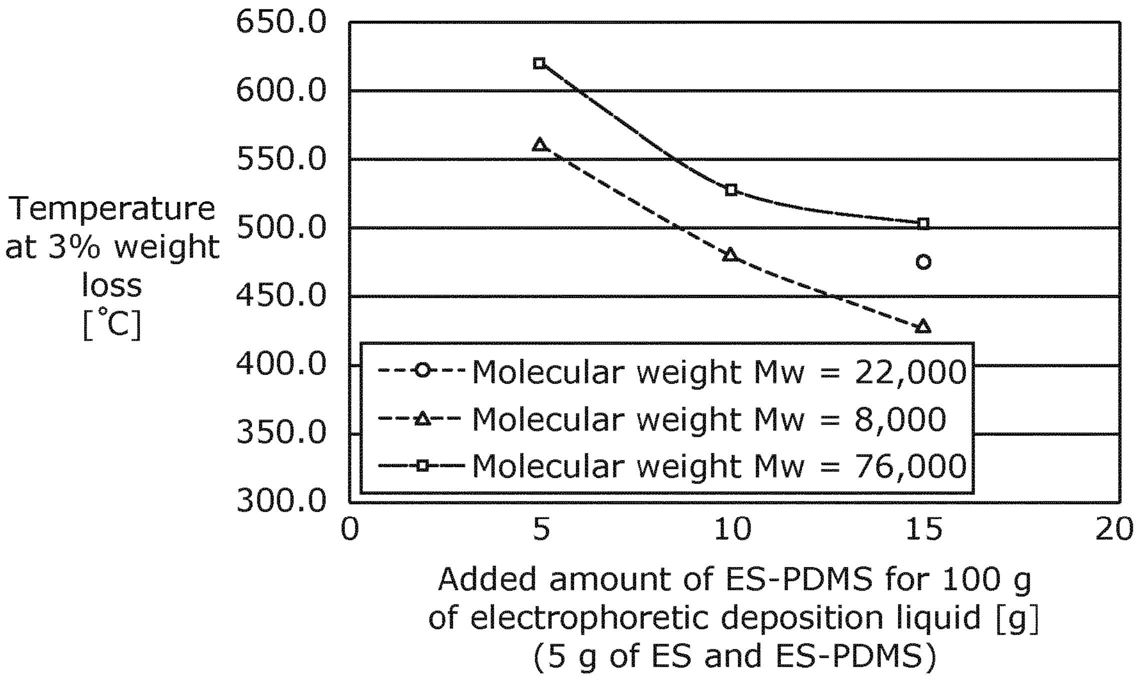

Temperature at 3% weight loss [°C]
650.0
600.0
550.0
500.0
450.0
400.0
350.0
300.0
0
5
10
15
20
Molecular weight Mw = 22,000
Molecular weight Mw = 8,000
Molecular weight Mw = 76,000
Added amount of ES-PDMS for 100 g of electrophoretic deposition liquid [g] (5 g of ES and ES-PDMS)

FIG. 26

(a)

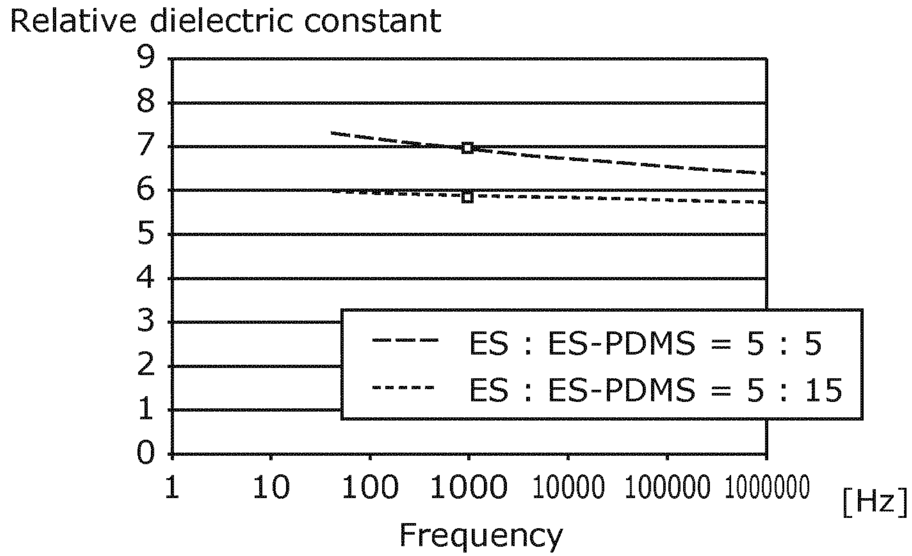


$$X\frac{\varepsilon_1 - \varepsilon_{eff}}{\varepsilon_1 + 2\varepsilon_{eff}} + (1 - X)\frac{\varepsilon_2 - \varepsilon_{eff}}{\varepsilon_2 + 2\varepsilon_{eff}} = 0$$

(b)

(c)

| ES : ES-PDMS | Relative dielectric constant | Estimate by measurement of dielectric constant | Estimate from TG measurement and specific gravity measurement |
|---|---|---|---|
| 5 : 5 | 6.9 ± 0.4 | 74 ± 7% | 78% |
| 5 : 15 | 5.9 ± 0.4 | 59 ± 7% | 53% |

FIG. 27

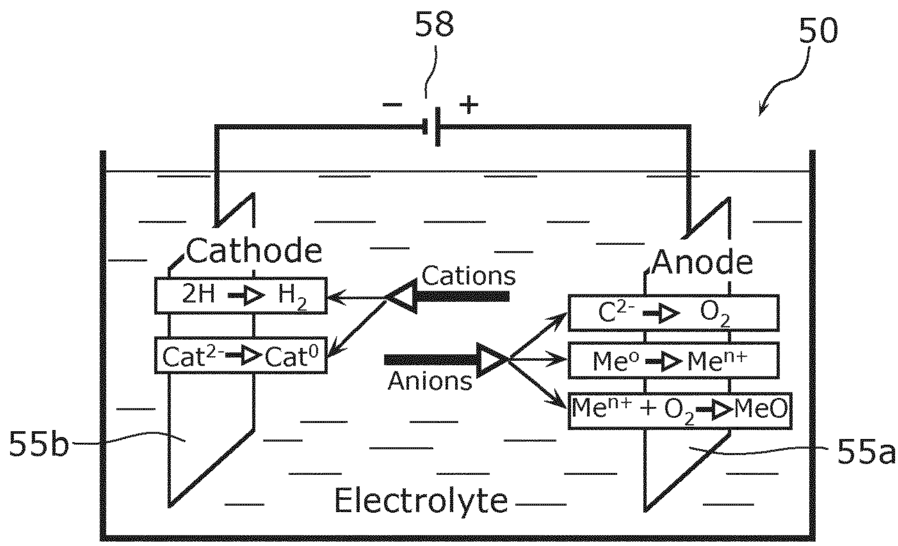
58
50
−
+
Cathode
2H → H2
Cat2- → Cat0
Cations
Anions
Anode
C2- → O2
Meo → Men+
Men+ + O2 → MeO
55b
55a
Electrolyte

FIG. 28

| Item of comparison | Normal aluminum | Aluminum subjected to PEO |
|---|---|---|
| Hardness (Hv) | 30 - 100 | 800 - 1400 |
| Corrosion resistance (salt spray corrosion resistance, time) | < 100 | < 5000 |
| Instant heat resistance (˚C) | 640 | 2000 |
| Electrical insulating properties (V/μm) | 0 | 2.5kV/50μm |

FIG. 29A

400-fold

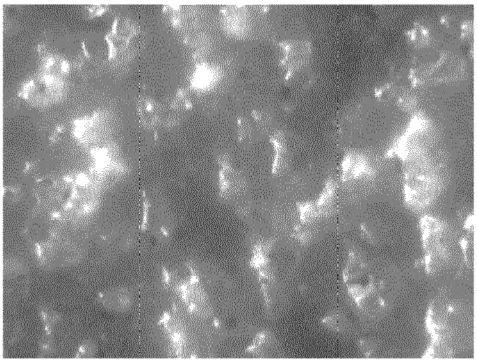

FIG. 29B

400-fold

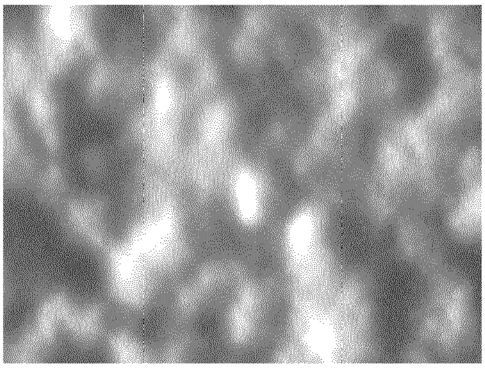

FIG. 29C

400-fold

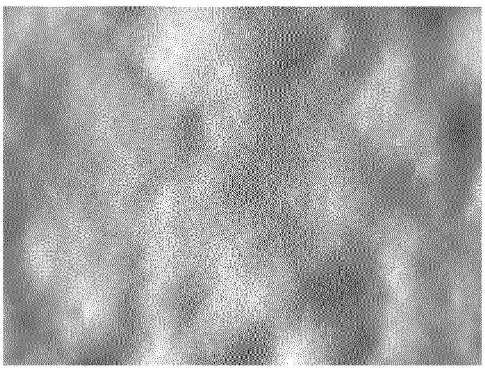

FIG. 30

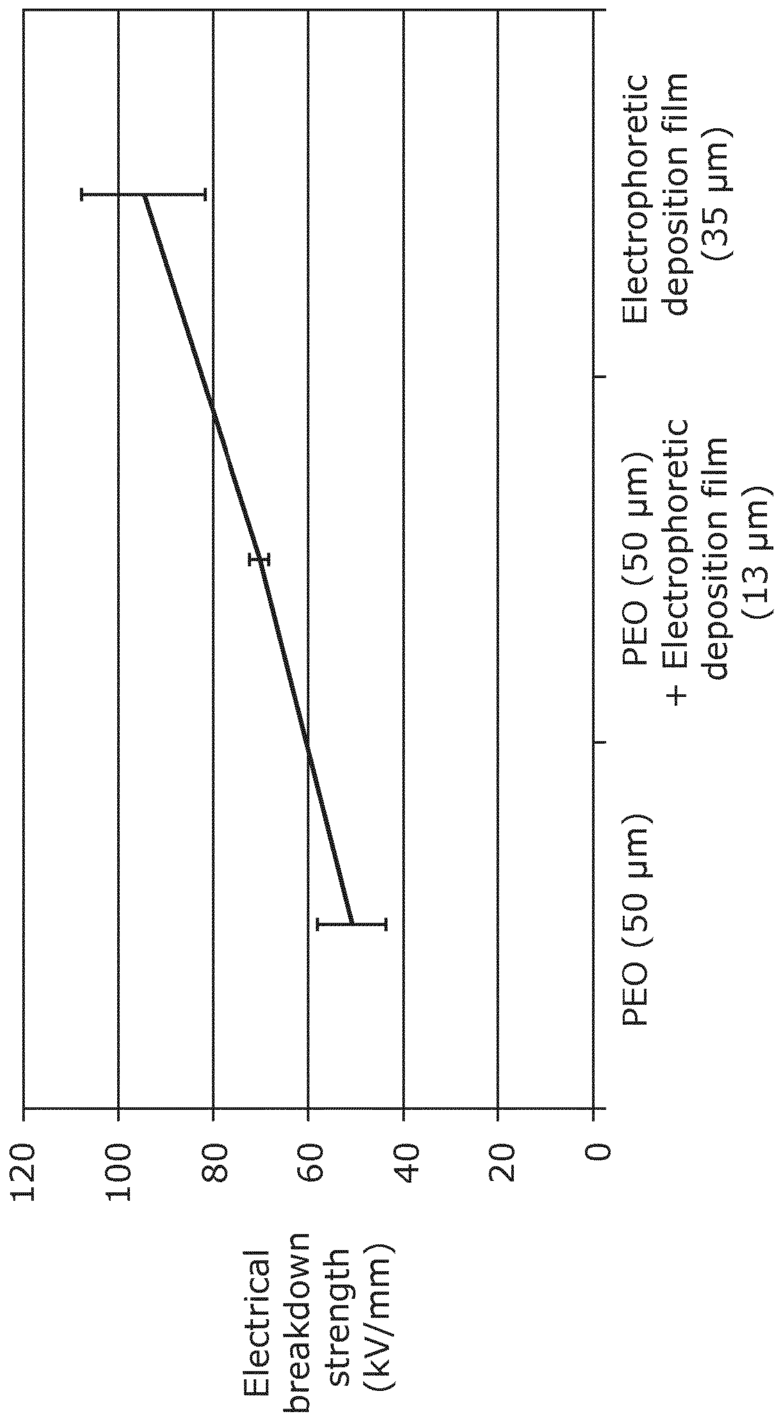
Electrical breakdown strength (kV/mm)
120
100
80
60
40
20
0
PEO (50 µm)
PEO (50 µm) + Electrophoretic deposition film (13 µm)
Electrophoretic deposition film (35 µm)

FIG. 31

| Item of comparison | PEO film | Electrophoretic deposition film according to the present technology | PEO film sealed with electrophoretic deposition film |
|---|---|---|---|
| Thickness (μm) | 50 | 35 | 63 |
| Dielectric withstand voltage (kV) | 2.5 | 3.4 | 3.8 |
| Thermal conductivity (W/mK) | 0.89 | 2.56 | 1.71 |

FIG. 32

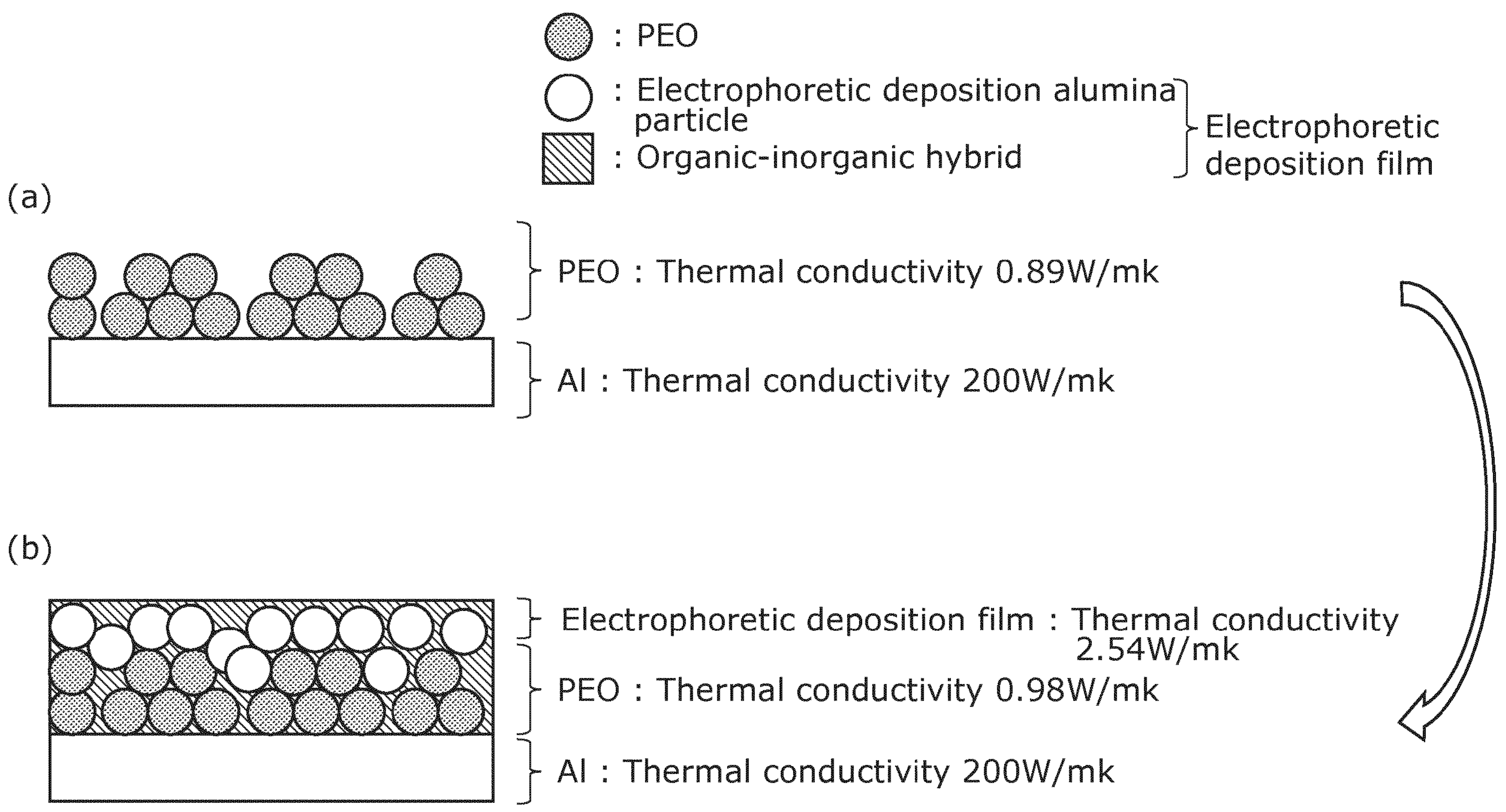
: PEO
: Electrophoretic deposition alumina particle
: Organic-inorganic hybrid
Electrophoretic deposition film
(a)
PEO : Thermal conductivity 0.89W/mk
Al : Thermal conductivity 200W/mk
(b)
Electrophoretic deposition film : Thermal conductivity 2.54W/mk
PEO : Thermal conductivity 0.98W/mk
Al : Thermal conductivity 200W/mk

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003209329 A
- WO 2014150841 A
- JP 3274154 B
- US 4755551 A
- WO 2010143357 A